# EUROPEAN PATENT APPLICATION

(11) **EP 4 438 297 A1**
(43) Date of publication of application: **02.10.2024**
(21) Application number: 22898250.0
(22) Date of filing: 07.10.2022
(51) Int. Cl.: B32B 27/38, B32B 27/18, C08K 3/01, C08L 63/00, C08L 67/00, H01F 1/26, H01F 1/37, H01F 17/00, H05K 1/03

(54) **RESIN SHEET**

(30) Priority: 25.11.2021 JP 2021191558
(71) Applicant: AJINOMOTO CO., INC., Chuo-ku Tokyo 104-8315 (JP)
(72) Inventor: TANAKA, Takayuki, Kawasaki-shi, Kanagawa 210-0801 (JP)
(74) Representative: Mewburn Ellis LLP
(86) International application number: PCT/JP2022/037677
(87) International publication number: WO 2023/095466

(57) **Abstract**

Provided are a resin sheet and the like that can yield a cured product with a high relative permeability and excellent mechanical strength. A resin sheet includes a support, and a resin composition layer formed of a resin composition provided on the support. The resin composition includes a magnetic powder (A), an epoxy resin (B), a dispersant (C), a curing agent (D), and a thermoplastic resin (E), and the component (C) has a polyester skeleton represented by the following general formula (1). In the general formula (1), Rs each independently represent a hydrocarbon group of 2 to 10 carbon atoms, and n represents an integer of 2 to 1,000.

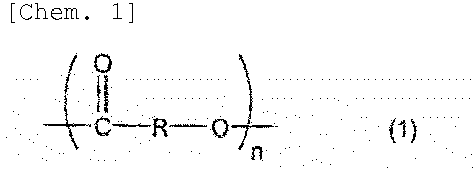

## Description

### Field

The present invention relates to a resin sheet, a resin composition, and a circuit board using the resin sheet or the resin composition and an inductor component.

### Background

An inductor built-in board, in which an inductor is built into a circuit board such as a printed wiring board, is generally formed using a resin composition including a magnetic powder. In order to increase the inductance of the inductor included in the inductor built-in board, a method of increasing the content of the magnetic powder in the resin composition or increasing the effective magnetic permeability of the magnetic layer, which is a cured product of the resin composition, is known.

For example, Patent literature 1 describes a resin sheet highly filled with a magnetic filler having an average particle diameter of 10 µm or more.

### Citation List

### Patent Literature

Patent Literature 1: Japanese Patent Application Laid-Open No. 2014-127624 A

### Summary

### Technical Problem

In recent years, there is a demand for further increasing the inductance. It is conceivable that the content of the magnetic powder may be increased in order to increase the relative permeability of the inductor. However, increasing the content of the magnetic powder may reduce the mechanical strength (tensile strength at break) of the magnetic layer.

It is conceivable that the magnetic powder with a large average particle diameter or the magnetic powder with a flat shape may be used to increase the relative permeability. However, using such a magnetic powder may increase the magnetic loss, resulting in a reduction in the inductor performance. Furthermore, it is conceivable that the magnetic powder with a small average particle diameter may be used. However, although using such a magnetic powder tends to reduce the magnetic loss, the relative permeability also tends to decrease.

The present invention has been made in view of the above-mentioned circumstances, and an object of the present invention is to provide a resin sheet and a resin composition that can yield a cured product with a high relative permeability and excellent mechanical strength, and a circuit board using the resin sheet or the resin composition and an inductor component.

### Solution to Problem

As a result of intensive studies to achieve the above-mentioned object, the present inventor has found that, when a resin sheet including a resin composition layer formed of a resin composition including a dispersant having a polyester skeleton is used, a cured product of the resin composition layer exhibits a high relative permeability and also excellent mechanical strength, thereby completing the present invention.

Namely, the present invention includes following contents.
[1]. A resin sheet comprising: a support; and a resin composition layer formed of a resin composition provided on the support, wherein
   the resin composition includes
      a magnetic powder (A),
      an epoxy resin (B),
      a dispersant (C),
      a curing agent (D), and
      a thermoplastic resin (E), and
   the component (C) has a polyester skeleton represented by the following general formula (1): 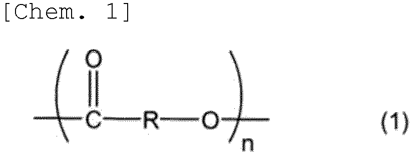 (in the general formula (1), Rs each independently represent a hydrocarbon group of 2 to 10 carbon atoms, and n represents an integer of 2 to 1,000).
[2]. The resin sheet according to [1], wherein a content of the component (C) is 0.1% by mass or more, and 5% by mass or less, when a nonvolatile component in the resin composition is defined as 100% by mass.
[3]. The resin sheet according to [1] or [2], wherein the component (A) includes a magnetic powder (A-1) with an average particle diameter of 1 µm or more and a magnetic powder (A-2) with an average particle diameter of less than 1 µm.
[4]. The resin sheet according to any one of [1] to [3], wherein the component (A) includes a magnetic powder (A-1) with an average particle diameter of 1 µm or more and 10 µm or less and a magnetic powder (A-2) with an average particle diameter of 0.005 µm or more and less than 1 µm.
[5]. The resin sheet according to any one of [1] to [4], wherein the component (A) is at least one type selected from an iron oxide powder and an iron alloy metal powder.
[6]. The resin sheet according to any one of [1] to [5], wherein the component (A) includes an iron oxide powder, and the iron oxide powder includes a ferrite including at least one type selected from Ni, Cu, Mn, and Zn.
[7]. The resin sheet according to any one of [1] to [6], wherein a content of the component (A) is 70% by mass or more and 98% by mass or less, when a nonvolatile component in the resin composition is defined as 100% by mass.
[8]. The resin sheet according to any one of [1] to [7], wherein, when a mass (% by mass) of the thermoplastic resin (E) is defined as E1 when a nonvolatile component in the resin composition is defined as 100% by mass, and a mass (% by mass) of the epoxy resin (B) is defined as B1 when the nonvolatile component in the resin composition is defined as 100% by mass, B1/E1 is 0.1 or more and 5 or less.
[9]. The resin sheet according to any one of [1] to [8], used for forming a magnetic layer of a circuit board.
[10]. The resin sheet according to any one of [1] to [9], used for filling a through hole.
[11]. A circuit board comprising a magnetic layer that is a cured product of the resin composition layer of the resin sheet according to any one of [1] to [10].
[12]. A circuit board comprising a substrate in which a through hole has been formed, and a magnetic layer filled in the through hole, wherein
   the magnetic layer includes a cured product of the resin composition layer of the resin sheet according to any one of [1] to [10].
[13]. An inductor component comprising the circuit board according to [11] or [12].
[14]. A resin composition comprising:
   a magnetic powder (A);
   an epoxy resin (B);
   a dispersant (C);
   a curing agent (D); and
   a thermoplastic resin (E), wherein:
      when a mass (% by mass) of the thermoplastic resin (E) is defined as E1 when a nonvolatile component in the resin composition is defined as 100% by mass, and a mass (% by mass) of the epoxy resin (B) is defined as B1 when the nonvolatile component in the resin composition is defined as 100% by mass, B1/E1 is 0.1 or more and 5 or less, and
      the component (C) has a polyester skeleton represented by the following general formula (1). 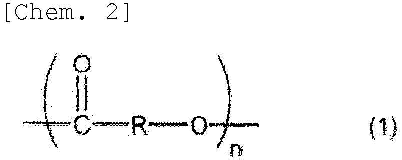 (in the general formula (1), Rs each independently represent a hydrocarbon group of 2 to 10 carbon atoms, and n represents an integer of 2 to 1,000).
[15]. A circuit board comprising a magnetic layer that is a cured product of the resin composition according to [14].
[16]. A circuit board comprising a substrate having a through hole, and a cured product of the resin composition according to [14], the cured product being filled in the through hole.
[17]. An inductor component comprising the circuit board according to [15] or [16].

### Advantageous Effects of Invention

According to the present invention, it is possible to provide the resin sheet that can yield the cured product with a high relative permeability and excellent mechanical strength, and the circuit board using the resin sheet and the inductor component.

### Brief Description of Drawings

FIG. 1 is a cross-sectional view schematically showing a core substrate before through holes are formed in a method for producing a circuit board of a first embodiment.
FIG. 2 is a cross-sectional view schematically showing the core substrate after the through holes have been formed in the method for producing the circuit board of the first embodiment.
FIG. 3 is a cross-sectional view schematically showing the core substrate in which a plating layer has been formed in the through holes in the method for producing the circuit board of the first embodiment.
FIG. 4 is a cross-sectional view schematically showing a state in which the core substrate and a resin sheet are laminated in the method for producing the circuit board of the first embodiment.
FIG. 5 is a cross-sectional view schematically showing a state after the core substrate and the resin sheet are laminated in the method for producing the circuit board of the first embodiment.
FIG. 6 is a schematic cross-sectional view for explaining a step (2) in the method for producing the circuit board of the first embodiment.
FIG. 7 is a schematic cross-sectional view for explaining a step (3) in the method for producing the circuit board of the first embodiment.
FIG. 8 is a schematic cross-sectional view for explaining a step (5) in the method for producing the circuit board of the first embodiment.
FIG. 9 is a schematic cross-sectional view for explaining the step (5) in the method for producing the circuit board of the first embodiment.
FIG. 10 is a schematic cross-sectional view for explaining an (A) step in a method for producing a circuit board of a second embodiment.
FIG. 11 is a schematic cross-sectional view for explaining the (A) step in the method for producing the circuit board of the second embodiment.
FIG. 12 is a schematic cross-sectional view for explaining a (B) step in the method for producing the circuit board of the second embodiment.
FIG. 13 is a schematic cross-sectional view for explaining a (D) step in the method for producing the circuit board of the second embodiment.
FIG. 14 is a schematic plan view of an inductor component including the circuit board obtained by the method for producing the circuit board of the second embodiment, viewed from one side in the thickness direction.
FIG. 15 is a schematic diagram showing a cut end surface of the inductor component including the circuit board obtained by the method for producing the circuit board of the second embodiment, cut at a position indicated by a dashed line II-II.
FIG. 16 is a schematic plan view for explaining a configuration of a first conductor layer of the inductor component including the circuit board obtained by the method for producing the circuit board of the second embodiment.

### Description of Embodiments

Hereinafter, embodiments of the present invention will be described with reference to the drawings. It should be noted that each of the drawings schematically illustrates the shape, size, and arrangement of components to the extent that the invention can be understood. The present invention is not limited by the following description, and each component can be changed as appropriate. In the drawings used in the following description, the same components are denoted by the same reference numerals, and redundant descriptions thereof may be omitted. Furthermore, the configuration according to the embodiment of the present invention is not necessarily produced or used by the arrangement of the illustrated examples.

### [Resin sheet]

A resin sheet of the present invention is a resin sheet including a support and a resin composition layer formed of a resin composition provided on the support. The resin composition includes a magnetic powder (A), an epoxy resin (B), a dispersant (C), a curing agent (D), and a thermoplastic resin (E), and the component (C) has a polyester skeleton represented by the following general formula (1). 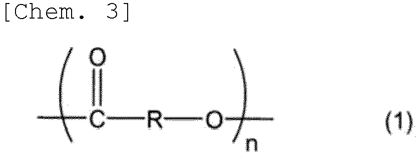 (in the general formula (1), Rs each independently represent a hydrocarbon group of 2 to 10 carbon atoms, and n represents an integer of 2 to 1,000.)

In the present invention, the resin composition including the dispersant (C) can yield a cured product with a high relative permeability and excellent mechanical strength. Furthermore, the cured product can usually reduce magnetic loss. Each of the layers constituting the resin sheet will be described in detail below.

### <Support>

Examples of the support may include a film made of a plastic material, a metal foil, and a release paper. A film made of a plastic material and a metal foil are preferable, and a film made of a plastic material is more preferable.

When a film made of a plastic material is used as the support, examples of the plastic material may include: a polyester such as polyethylene terephthalate (hereinafter also abbreviated as "PET") and polyethylene naphthalate (hereinafter also abbreviated as "PEN"); a polycarbonate (hereinafter also abbreviated as "PC"); an acrylic polymer such as polymethyl methacrylate (hereinafter also abbreviated as "PMMA"); a cyclic polyolefin; a triacetylcellulose (hereinafter also abbreviated as "TAC"); a polyether sulfide (hereinafter also abbreviated as "PES"); a polyether ketone; and a polyimide. Among these, polyethylene terephthalate and polyethylene naphthalate are preferable, and inexpensive polyethylene terephthalate is particularly preferable.

When a metal foil is used as the support, examples of the metal foil may include a copper foil and an aluminum foil. Among these, a copper foil is preferable. As the copper foil, a foil made of a single copper metal may be used, or a foil made of an alloy of copper and other metals (e.g., tin, chromium, silver, magnesium, nickel, zirconium, silicon, titanium, etc.) may be used.

The surface of the support to be bonded to the resin composition layer may be subjected to a treatment such as a matte treatment, a corona treatment, or an antistatic treatment.

Furthermore, as the support, a support with release layer, which includes a release layer on the surface to be bonded to the resin composition layer, may be used. Examples of a release agent used in the release layer of the support with release layer may include one or more types of release agents selected from the group consisting of an alkyd resin, a polyolefin resin, a urethane resin, and a silicone resin. Examples of a commercially available release agent may include "SK-1", "AL-5", and "AL-7" manufactured by Lintec Corp., which are alkyd resin-based release agents. Furthermore, examples of the support with release layer may include: "LUMIRROR T60" manufactured by Toray Industries, Inc.; "PUREX" manufactured by Teijin Ltd.; and "UNIPEEL" manufactured by Unitika Ltd.

The thickness of the support is preferably in a range of 5 µm to 75 µm, and more preferably in a range of 10 µm to 60 µm. Note that, when the support with release layer is used, the entire thickness of the support with release layer is preferably within the above-described ranges.

### <Resin composition layer>

In the resin sheet of the present invention, the resin composition layer provided on the support is formed of a resin composition, and the resin composition includes a magnetic powder (A), an epoxy resin (B), a dispersant (C), a curing agent (D), and a thermoplastic resin (E), and the component (C) has a polyester skeleton represented by the following general formula (1). 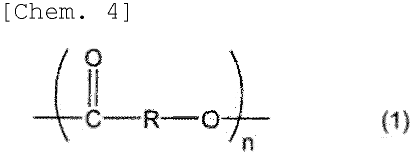 (in the general formula (1), Rs each independently represent a hydrocarbon group of 2 to 10 carbon atoms, and n represents an integer of 2 to 1,000)

The resin composition may further include an optional component in combination with the components (A) to (E). Examples of the optional component may include other additives (F) and a solvent (G). Each component included in the resin composition will be described in detail below.

### - Magnetic powder (A) -

The resin composition includes a magnetic powder (A) as the component (A). As the magnetic powder (A), a particle of a material having a relative permeability of greater than 1 can be used. The material of the magnetic powder (A) is usually an inorganic material and may be a soft magnetic material or a hard magnetic material. As the magnetic powder (A), one type thereof may be solely used, and two or more types thereof may also be used in combination. Thus, the magnetic powder (A) may be a soft magnetic powder, a hard magnetic powder, or a combination of a soft magnetic powder and a hard magnetic powder.

Examples of the magnetic powder (A) may include: a pure iron powder; an iron oxide powder such as an Mg-Zn ferrite, a Fe-Mn ferrite, an Mn-Zn ferrite, an Mn-Mg ferrite, a Cu-Zn ferrite, an Mg-Mn-Sr ferrite, an Ni-Zn ferrite, a Ba-Zn ferrite, a Ba-Mg ferrite, a Ba-Ni ferrite, a Ba-Co ferrite, a Ba-Ni-Co ferrite, a Y-type ferrite, an iron oxide powder (III), and triiron tetroxide; an iron alloy metal powder such as a Fe-Si alloy powder, a Fe-Si-Al alloy powder, a Fe-Cr alloy powder, a Fe-Cr-Si alloy powder, a Fe-Ni-Cr alloy powder, a Fe-Cr-Al alloy powder, a Fe-Ni alloy powder, a Fe-Ni-Mo alloy powder, a Fe-Ni-Mo-Cu alloy powder, a Fe-Co alloy powder, and a Fe-Ni-Co alloy powder; and an amorphous alloy such as a Co-based amorphous.

Among these, the magnetic powder (A) is preferably at least one type selected from an iron oxide powder and an iron alloy metal powder. The iron oxide powder preferably includes a ferrite including at least one type selected from Ni, Cu, Mn, and Zn, and the iron oxide powder more preferably includes a ferrite including either Mn or Zn. Furthermore, the iron alloy metal powder preferably includes an iron alloy metal powder including at least one type selected from Si, Cr, Al, Ni, and Co, and the iron alloy metal powder more preferably includes an iron alloy metal powder including Ni.

As the magnetic powder (A), a commercially available magnetic powder can be used. Specific examples of the commercially available magnetic powder that can be used may include: "MOSS", "MOSS", "MZ03S", and "M001" manufactured by Powdertech; "MA-RCO-24" manufactured by Dowa Electronics Materials Co., Ltd.; "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", and "Fe-80Ni-4MoPF20F" manufactured by Epson Atmix Corp; "LD-M", "LD-MH", "KNI-106", "KNI-106GSM", "KNI-106GS", "KNI-109", "KNI-109GSM", and "KNI-109GS" manufactured by JFE Chemical Corp.; "KNS-415", "BSF-547", "BSF-029", "BSN-125", "BSN-714", "BSN-828", "S-1281", "S-1641", "S-1651", "S-1470", "S-1511", and "S-2430" manufactured by Toda Kogyo Corp.; "JR09P2" manufactured by Japan Metals & Chemicals Co., Ltd.; "Nanotek" manufactured by CIK-Nano Tek; "JEMK-S" and "JEMK-H" manufactured by Kinsei Matec Co., Ltd.; and "Yttrium iron oxide" manufactured by Sigma-Aldrich.

As the magnetic powder (A), one type thereof may be solely used, and two or more types thereof may also be used in combination from the viewpoint of significantly obtaining the advantageous effects of the present invention.

The magnetic powder (A) is preferably spherical. A value (aspect ratio) obtained by dividing the length of the long axis of the magnetic powder by the length of the short axis is preferably 2 or less, more preferably 1.5 or less, and further preferably 1.2 or less. In general, it is easier to improve the relative permeability of the magnetic powder when it has a flat shape rather than a spherical shape. However, it is usually preferable to use the magnetic powder having, in particular, a spherical shape from the viewpoint of reducing the magnetic loss.

The average particle diameter of the magnetic powder (A) is preferably 0.01 µm or more, more preferably 0.5 µm or more, and further preferably 1 µm or more, from the viewpoint of improving the relative permeability. Furthermore, the average particle diameter is preferably 10 µm or less, more preferably 9 µm or less, and further preferably 8 µm or less. Note that, when two or more types of the magnetic powders (A) are used in combination, the average particle diameter of the entire component (A) may be within these ranges.

The average particle diameter of the magnetic powder can be measured using a laser diffraction scattering method based on the Mie scattering theory. Specifically, the average particle diameter can be measured by creating a particle size distribution of the magnetic powder on a volume basis using the laser diffraction scattering type particle size distribution measurement apparatus, and using a median diameter as the average particle diameter. As the measurement sample, a magnetic powder dispersed in water using ultrasonic waves may be preferably used. As the laser diffraction scattering type particle size distribution measurement apparatus, "LA-500" manufactured by Horiba, Ltd., "SALD-2200" manufactured by Shimadzu Corp., or the like can be used.

The specific surface area of the magnetic powder (A) is preferably 0.05 m²/g or more, more preferably 0.1 m²/g or more, and further preferably 0.3 m²/g or more, from the viewpoint of improving the relative permeability. Furthermore, the specific surface area is preferably 10 m²/g or less, more preferably 8 m²/g or less, and further preferably 5 m²/g or less. The specific surface area of the magnetic powder(A) can be measured by the BET method. Note that when two or more types of the magnetic powders (A) are used in combination, the specific surface area of the entire component (A) may be within these ranges.

The magnetic powder (A) preferably includes a magnetic powder (A-1) with an average particle diameter of 1 µm or more and a magnetic powder (A-2) with an average particle diameter of less than 1 µm, from the viewpoint of improving the relative permeability.

The average particle diameter of the magnetic powder (A-1) with an average particle diameter of 1 µm or more is 1 µm or more, preferably 1.2 µm or more, and more preferably 1.5 µm or more. The upper limit of the average particle diameter of the component (A-1) is preferably 10 µm or less, more preferably 9 µm or less, and further preferably 8 µm or less. The average particle diameter of the component (A-1) can be measured by the method described above.

The specific surface area of the component (A-1) is preferably 0.01 m²/g or more, more preferably 0.05 m²/g or more, and further preferably 0.1 m²/g or more. Furthermore, the specific surface area is preferably 2 m²/g or less, more preferably 1.5 m²/g or less, and further preferably 1 m²/g or less. The specific surface area of the component (A-1) can be measured by the method described above.

The average particle diameter of the magnetic powder (A-2) with an average particle diameter of less than 1 µm is less than 1 µm, preferably 0.8 µm or less, and more preferably 0.5 µm or less. The lower limit of the average particle diameter of the component (A-2) is preferably 0.005 µm or more, more preferably 0.01 µm or more, and further preferably 0.02 µm or more. The average particle diameter of the component (A-2) can be measured by the method described above.

The specific surface area of the component (A-2) is preferably 1 m²/g or more, more preferably 2 m²/g or more, and further preferably 3 m²/g or more. Furthermore, the specific surface area is preferably 500 m²/g or less, more preferably 400 m²/g or less, and further preferably 300 m²/g or less. The specific surface area of the component (A-2) can be measured by the method described above.

A preferable embodiment of the component (A) preferably includes the magnetic powder (A-1) with an average particle diameter of 1 µm or more and 10 µm or less and the magnetic powder (A-2) with an average particle diameter of 0.005 µm or more and less than 1 µm, more preferably includes the magnetic powder (A-1) with an average particle diameter of 1.2 µm or more and 9 µm or less and the magnetic powder (A-2) with an average particle diameter of 0.01 µm or more and less than 0.8 µm, and further preferably includes the magnetic powder (A-1) with an average particle diameter of 1.5 µm or more and 8 µm or less and the magnetic powder (A-2) with an average particle diameter of 0.02 µm or more and less than 0.5 µm.

The content (% by volume) of the magnetic powder (A) is preferably 40% by volume or more, more preferably 50% by volume or more, and further preferably 60% by volume or more, when the nonvolatile component in the resin composition is defined as 100% by volume, from the viewpoint of improving the relative permeability and reducing the loss coefficient. Furthermore, the content is preferably 85% by volume or less, more preferably 80% by volume or less, and further preferably 70% by volume or less.

The content (% by mass) of the magnetic powder (A) is preferably 70% by mass or more, more preferably 75% by mass or more, and further preferably 80% by mass or more or 90% by mass or more, when the nonvolatile component in the resin composition is defined as 100% by mass, from the viewpoint of improving the relative permeability and reducing the loss coefficient. Furthermore, the content is preferably 98% by mass or less, more preferably 97% by mass or less, and further preferably 96% by mass or less or 95% by mass or less.

Note that, in the present invention, the content of each component in the resin composition is a value when the nonvolatile component in the resin composition is defined as 100% by mass, unless otherwise specified.

When the component (A) includes the component (A-1) and the component (A-2), the content (% by mass) of the component (A-1) is preferably 50% by mass or more, more preferably 60% by mass or more, and further preferably 70% by mass or more, when the nonvolatile component in the resin composition is defined as 100% by mass, from the viewpoint of improving the relative permeability and reducing the loss coefficient. Furthermore, the content is preferably 90% by mass or less, more preferably 85% by mass or less, and further preferably 80% by mass or less.

When the component (A) includes the component (A-1) and the component (A-2), the content (% by mass) of the component (A-2) is preferably 10% by mass or more, more preferably 15% by mass or more, and further preferably 20% by mass or more, when the nonvolatile component in the resin composition is defined as 100% by mass, from the viewpoint of improving the relative permeability and reducing the loss coefficient. Furthermore, the content is preferably 50% by mass or less, more preferably 40% by mass or less, and further preferably 30% by mass or less.

Provided that the content (% by mass) of the component (A-1) is defined as a1 when the nonvolatile component in the resin composition is defined as 100% by mass, and that the content (% by mass) of the component (A-2) is defined as a2 when the nonvolatile component in the resin composition is defined as 100% by mass, a1/a2 is preferably 10 or less, more preferably 8 or less, and further preferably 5 or less, and preferably 1 or more, more preferably 2 or more, and further preferably 3 or more. Adjusting the content of the component (A) so that a1/a2 falls within these ranges makes it possible to more significantly obtain the desired advantageous effects of the present invention.

### - (B) Epoxy resin -

The resin composition includes an epoxy resin (B) as the component (B).
Examples of the epoxy resin (B) may include a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolac type epoxy resin; a tert-butyl-catechol type epoxy resin; an epoxy resin having a condensed ring structure such as a naphthol novolac type epoxy resin, a naphthalene type epoxy resin, a naphthol type epoxy resin, and an anthracene type epoxy resin; a glycidyl amine type epoxy resin; a glycidyl ester type epoxy resin; a cresol novolac type epoxy resin; a biphenyl type epoxy resin; a linear aliphatic epoxy resin; an epoxy resin having a butadiene structure; an alicyclic epoxy resin; a heterocyclic epoxy resin; a spirocyclic epoxy resin; a cyclohexane dimethanol type epoxy resin; a trimethylol epoxy resin; a tetraphenylethane type epoxy resin; and a cycloaliphatic diglycidyl ether type epoxy resin. As the epoxy resin, one type thereof may be solely used, and two or more types thereof may also be used in combination. The epoxy resin (B) is preferably one or more types selected from a bisphenol A type epoxy resin and a bisphenol F type epoxy resin, and more preferably contains a bisphenol A type epoxy resin and a bisphenol F type epoxy resin.

The epoxy resin (B) preferably includes an epoxy resin having two or more epoxy groups within one molecule. The epoxy resin (B) preferably has an aromatic structure, and when two or more types of epoxy resins are used, it is more preferable that at least one type of epoxy resin has an aromatic structure. Aromatic structures are chemical structures that are generally defined as aromatic and also include polycyclic aromatic and aromatic heterocyclic rings. The proportion of the epoxy resin having two or more epoxy groups within one molecule relative to 100% by mass of the nonvolatile component of the epoxy resin is preferably 50% by mass or more, more preferably 60% by mass or more, and particularly preferably 70% by mass or more.

The epoxy resin may be classified into epoxy resins in a liquid state at a temperature of 25°C (hereinafter may be referred to as a "liquid epoxy resin") and epoxy resins in a solid state at a temperature of 25°C (hereinafter may be referred to as a "solid epoxy resin"). The resin composition may contain only a liquid epoxy resin, may contain only a solid epoxy resin, or may contain a combination of a liquid epoxy resin and a solid epoxy resin, as the epoxy resin (B). The resin composition preferably contains only a liquid epoxy resin from the viewpoint of lowering the viscosity of the resin composition.

As the liquid epoxy resin, a glycirol type epoxy resin, a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolak type epoxy resin, an alicyclic epoxy resin having an ester skeleton, a cyclohexanedimetanol type epoxy resin, a cyclic aliphatic diglycidyl ether type epoxy resin, a cyclic aliphatic glycidyl ether type epoxy resin, a cyclic aliphatic glycidyl ether type epoxy resin, and an epoxy resin having butadiene structure are preferable, and a bisphenol A type epoxy resin and a bisphenol F type epoxy resin are more preferable. Specific examples of the liquid epoxy resins may include "HP4032", "HP4032D", and "HP4032SS" (naphthalene type epoxy resin) manufactured by DIC Corp.; "828US", "jER828EL" (bisphenol A type epoxy resin), "jER807" (bisphenol F type epoxy resin), and "jER152" (phenol novolac type epoxy resin) manufactured by Mitsubishi Chemical Corporation; "630" and "630LSD" manufactured by Mitsubishi Chemical Corporation and "ED-523T" (glycilol type epoxy resin (adecaglycilol)), "EP-3980S" (glycidyl amine type epoxy resin), "EP-4088S" (dicyclopentadiene type epoxy resin) that are manufactured by ADEKA Corporation; "ZX1059"(mixed product of bisphenol A type epoxy resin and bisphenol F type epoxy resin), "EX-201" (cyclic aliphatic glycidyl ether type epoxy resin), and "ZX1658" add "ZX1658GS" (cyclic aliphatic diglycidyl ether type epoxy resin) that are manufactured by NIPPON STEEL Chemical & Material Co., Ltd.; "EX-721" (glycidyl ester type epoxy resin) manufactured by Nagase ChemteX Corp.; and "celloxide 2021P" (alicyclic epoxy resin having an ester skeleton) and "PB-3600" (epoxy resin having a butadiene structure) that are manufactured by Daicel Corp. As these liquid epoxy resins, one type thereof may be solely used, and two or more types thereof may also be used in combination.

As the solid epoxy resin, a naphthalene type 4-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, and a tetraphenylethane type epoxy resin are preferable. Specific examples of the solid epoxy resin may include "HP4032H" (naphthalene type epoxy resin), "HP-4700" and "HP-4710" (naphthalene type 4 functional epoxy resin), "N-690" (cresol novolac type epoxy resin), "N-695" (cresol novolac type epoxy resin), "HP-7200", "HP-7200HH", and "HP-7200H" (dicyclopentadiene type epoxy resin), "EXA-7311", "EXA-7311-G3", "EXA-7311-G4", "EXA-7311-G4S", and "HP6000" (naphthylene ether type epoxy resin) that are manufactured by DIC Corp.; "EPPN-502H" (trisphenol type epoxy resin), "NC7000L" (naphthol novolac type epoxy resin), "NC3000H", "NC3000", "NC3000L", and "NC3100" (biphenyl type epoxy resin) that are manufactured by Nippon Kayaku Co., Ltd.,; "ESN475V" (naphthalene type epoxy resin) and "ESN485" (naphthol novolac type epoxy resin) that are manufactured by NIPPON STEEL Chemical & Material Co., Ltd.; "YX4000H" and "YL6121" (biphenyl type epoxy resin), "YX4000HK" (bixylenol type epoxy resin), and "YX8800" (anthracene type epoxy resin) that are manufactured by Mitsubishi Chemical Corporation; and "PG-100" and "CG-500" that are manufactured by Osaka Gas Chemical Co., and "YL7760" (bisphenol A type epoxy resin), "YL7800" (fluorene type epoxy resin), "jER1010" (solid bisphenol A type epoxy resin), and "jER1031S" (tetraphenylethane type epoxy resin) that are manufactured by Mitsubishi Chemical Corporation. As these solid epoxy resins, one type thereof may be solely used, and two or more types thereof may also be used in combination.

When a liquid epoxy resin and a solid epoxy resin are used in combination as the epoxy resin (B), the amount ratio (liquid epoxy resin : solid epoxy resin) thereof is preferably in a range of 1:0.1 to 1:4 by mass ratio. When the amount ratio of the liquid epoxy resin to the solid epoxy resin is adjusted to be within such a range, it is possible to obtain advantageous effects such as capability of yielding a cured product having sufficient breaking strength. From the viewpoint of the abovementioned advantageous effects, the amount ratio of the liquid epoxy resin to the solid epoxy resin (liquid epoxy resin : solid epoxy resin) is more preferably in a range of 1:0.3 to 1:3.5 by mass ratio, further preferably in a range of 1:0.6 to 1:3, and particularly preferably in a range of 1:0.8 to 1:2.5.

The content of the epoxy resin (B) is preferably 0.1% by mass or more, more preferably 0.3% by mass or more, further preferably 0.5% by mass or more, and 1% by mass or more, when the nonvolatile component in the resin composition is defined as 100% by mass, from the viewpoint of obtaining a magnetic layer exhibiting favorable mechanical strength. The upper limit of the content of the epoxy resin is not particularly limited as long as the advantageous effects of the present invention are achieved, and is preferably 5% by mass or less, more preferably 3% by mass or less, and further preferably 2% by mass or less.

The content (% by volume) of the epoxy resin (B) is preferably 1% by mass or more, more preferably 3% by mass or more, and further preferably 5% by mass or more, when the nonvolatile component in the resin composition is defined as 100% by volume. The upper limit thereof is not particularly limited as long as the advantageous effects of the present invention are achieved, and is preferably 25% by mass or less, more preferably 20% by mass or less, and further preferably 15% by mass or less.

The epoxy equivalent of the epoxy resin (B) is preferably 50 g/eq. to 5,000 g/eq., more preferably 50 g/eq. to 3,000 g/eq., further preferably 80 g/eq. to 2,000 g/eq., and still further preferably 110 g/eq. to 1,000 g/eq. When the epoxy equivalent falls within this range, the crosslinking density of the cured product becomes sufficient, and a magnetic layer having a small surface roughness can be obtained. The epoxy equivalent can be measured according to JIS K7236 and refers to a mass of a resin containing one equivalent of an epoxy group.

The weight-average molecular weight of the epoxy resin (B) is preferably 100 to 5,000, more preferably 250 to 3,000, and further preferably 400 to 1,500. Herein, the weight-average molecular weight of the epoxy resin refers to a polystyrene-equivalent weight-average molecular weight measured by a gel permeation chromatography (GPC) method.

### - (C) Dispersant -

The resin composition includes, as the component (C), a dispersant (C) having a polyester skeleton represented by the following formula (1). 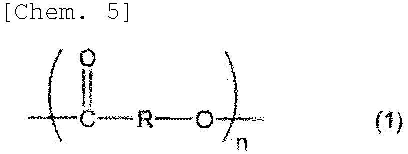 (in the general formula (1), Rs each independently represent a divalent hydrocarbon group of 2 to 10 carbon atoms, and n represents an integer of 2 to 1,000.)

As described above, when the content of the magnetic powder (A) is increased in order to improve the relative permeability, the mechanical strength of the cured product of the resin composition layer decreases. In the present invention, since the component (C) is contained as a dispersant in the resin composition, compared to the resin composition containing no component (C) (i.e., a resin composition having the same chemical composition as the resin composition except that it does not contain the component (C)), it is possible to improve the mechanical strength while improving the relative permeability.

The component (C) has a polyester skeleton represented by the general formula (1): 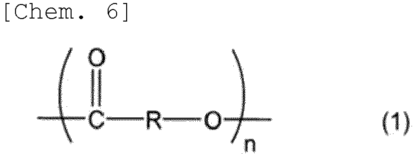 (in the general formula (1), Rs each independently represent a divalent hydrocarbon group of 2 to 10 carbon atoms, and n represents an integer of 2 to 1,000.)

R in the general formula (1) represents a divalent hydrocarbon group of 2 to 10 carbon atoms.
The number of carbon atoms in the hydrocarbon group is 2 or more, preferably 3 or more, and more preferably 4 or more. The upper limit of the number of carbon atoms is 10 or less, preferably 8 or less, and more preferably 6 or less. The hydrocarbon group may be linear, branched or cyclic, and is preferably a linear or branched hydrocarbon group. Examples of the hydrocarbon group may include an aliphatic hydrocarbon group and an aromatic hydrocarbon group, with an aliphatic hydrocarbon group being preferable. The hydrocarbon group may be either a saturated hydrocarbon group or an unsaturated hydrocarbon group, with a saturated hydrocarbon group being preferable. Specific examples of the hydrocarbon group may include an alkylene group, an alkenylene group, an alkynylene group, and an arylene group. Among these, an alkylene group is particularly preferable as the hydrocarbon group from the viewpoint of significantly obtaining the advantageous effects of the present invention.

Examples of the alkylene group may include an ethylene group, a propylene group, a butylene group, a pentylene group, a hexylene group, a heptylene group, an octylene group, a nonylene group, and a decylene group. Examples of the alkenylene group may include an ethenylene group, a propenylene group, a butenylene group, a pentenylene group, a hexenylene group, a heptenylene group, an octenylene group, a nonenylene group, and a decenylene group. Examples of the alkynylene group may include an ethynylene group, a pyropynylene group, a butynylene group, a pentynylene group, a hexynylene group, a heptynylene group, an octynylene group, a nonynylene group, and a decynylene group. Examples of the arylene group may include a phenylene group and a naphthylene group. Among these, R is preferably a butylene group or a pentylene group.

The divalent hydrocarbon group represented by R in the general formula (1) may or may not have a substituent. The substituent is not particularly limited, and examples thereof may include a halogen atom, -OH, an - O-C₁₋₆ alkyl group, an -N(C₁₋₁₀ alkyl group)₂, a C₁₋₁₀ alkyl group, a C₆₋₁₀ aryl group, -NH₂, -CN, a -C(O)O-C₁₋₁₀ alkyl group, -COOH, -C(O)H, and -NO₂.
Herein, the term "C_{p-q}" (p and q are positive integers, and satisfy p < q) means that the number of carbon atoms of the organic group described immediately after this term is p to q. For example, the expression "C₁₋₁₀ alkyl group" refers to an alkyl group of 1 to 10 carbon atoms. These substituents may be bonded to each other to form a ring, and the ring structure includes a spiro ring and a condensed ring.

The above-mentioned substituent may further have a substituent (hereinafter, may sometimes be referred to as a "secondary substituent"). As the secondary substituent, the same substituents as those described above may be used unless otherwise specified.

In the general formula (1), n represents an integer of 2 to 1,000. n is 2 or more, preferably 5 or more, and more preferably 10 or more. The upper limit is 1,000 or less, preferably 500 or less, more preferably 100 or less, and 50 or less.

The component (C) may contain an optional skeleton in addition to the polyester skeleton represented by the general formula (1) as long as the advantageous effects of the present invention are not impaired. Examples of the optional skeleton may include a polyester skeleton in which R in the general formula (1) is a divalent hydrocarbon group of 1 or 11 or more carbon atoms (n is the same as in the formula (1)), and a polyallylamine skeleton. For example, the terminal of the polyester skeleton is not particularly limited.

Examples of the terminal of the component (C) may include a residue of a carboxylic acid, a hydroxy group, and a hydrogen atom, which will be described later.

The component (C) having a polyester skeleton represented by the general formula (1) can be produced, for example, by reacting a lactone represented by the general formula (2) and a carboxylic acid. 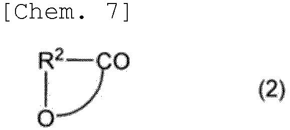 (in the general formula (2), R² is the same as R in the general formula (1).)

Examples of the lactone represented by the general formula (2) may include ε-caprolactone, β-propiolactone, γ-butyrolactone, δ-valerolactone, β-methyl-δ-valerolactone, 4-methylcaprolactone, and 2-methylcaprolactone.

As the carboxylic acid, one which functions as an initiator for ring-opening polymerization of the lactone represented by the general formula (2) can be used. Examples of such a carboxylic acid may include hydroxycarboxylic acids such as ricinolic acid, ricinoleic acid, 9 and 10-hydroxystearic acid, castor oil fatty acids, hydrogenated castor oil fatty acids, lactic acid, 12-hydroxystearic acid, and glycolic acid; dodecanoic acid, and stearic acid. Among these, a hydroxycarboxylic acid is preferable from the viewpoint of significantly obtaining the advantageous effects of the present invention.

The reaction temperature is preferably 120 to 220°C, and more preferably 160 to 210°C. The reaction time is preferably 0.5 to 72 hours. When the reaction is performed under a stream of nitrogen, a polyester having a high degree of polymerization can be obtained.

As the reaction, a polymerization catalyst or a polymerization initiator may be used as necessary from the viewpoint of controlling the reaction.

Examples of the polymerization catalyst may include quaternary ammonium salts such as tetramethylammonium chloride, tetrabutylammonium chloride, tetramethylammonium bromide, tetrabutylammonium bromide, tetramethylammonium iodide, tetrabutylammonium iodide, benzyltrimethylammonium chloride, benzyltrimethylammonium bromide, and benzyltrimethylammonium iodide; quaternary phosphonium salts such as tetramethylphosphonium chloride, tetrabutylphosphonium chloride, tetramethylphosphonium bromide, tetrabutylphosphonium bromide, tetramethylphosphonium iodide, tetrabutylphosphonium iodide, benzyltrimethylphosphonium chloride, benzyltrimethylphosphonium bromide, benzyltrimethylphosphonium iodide, tetraphenylphosphonium chloride, tetraphenylphosphonium bromide, and tetraphenylphosphonium iodide; phosphorus compounds such as triphenylphosphine; organic carboxylic acid salts such as potassium acetate, sodium acetate, potassium benzoate, and sodium benzoate; alkali metal alcoholates such as sodium alcoholate and potassium alcoholate; tertiary amines; organotin compounds; organoaluminum compounds; organotitanate compounds such as tetrabutyltitanate; and zinc compounds such as zinc chloride.

Examples of the polymerization initiator may include aliphatic monocarboxylic acids such as acetic acid, propionic acid, caprylic acid, nonanoic acid, capric acid, octylic acid, laurylic acid, myristic acid, palmitic acid, stearic acid, isononanoic acid, and arachidic acid; and aromatic monocarboxylic acids such as benzoic acid and p-butylbenzoic acid.

In the production of the component (C), an optional monomer may be further used in addition to the lactone represented by the general formula (2) and a carboxylic acid as long as the advantageous effects of the present invention are not impaired. Examples of the optional monomer may include a polyallylamine. For example, when a polyallylamine is used as an optional monomer, the component (C) containing a polyallylamine skeleton in addition to the polyester skeleton represented by the general formula (1) can be produced. The reaction temperature and the reaction time are the same as the reaction temperature and the reaction time in the production of the component (C) having the polyester skeleton represented by the general formula (1).

The polyallylamine is obtained by polymerizing an allylamine in the presence of a polymerization initiator and/or a chain transfer catalyst.

The polymerization initiator is not particularly limited, and examples thereof may include ketone peroxides such as methyl ethyl ketone, diacyl peroxides such as benzoyl peroxide, peroxydicarbonates such as diisopropyl peroxydicarbonate, peroxyketals such as 1,1-bis(t-butylperoxy)cyclohexane, hydroperoxides such as t-butyl hydroperoxide, peroxyesters such as t-butyl peroxypivalate, azobisisoptylonitrile, hydrogen peroxide, and ferrous salt. Furthermore, the polymerization initiator described in Japanese Examined Patent Publication No. Hei. 2-14364 B may be used. As these polymerization initiators, one type thereof may be solely used, and two or more types thereof may also be used in combination.

The chain transfer catalyst is not particularly limited, and examples thereof may include alkyl mercaptans such as lauryl mercaptan, thiocarboxylic acids such as mercaptoacetic acid, 2-mercaptopropionic acid, and 3-mercaptopropionic acid, and thiocarboxylic acid esters such as butyl thioglycolate and 2-ethylhexyl thioglycolate. As these chain transfer catalysts, one type thereof may be solely used, and two or more types thereof may also be used in combination.

The weight-average molecular weight of the polyallylamine is preferably 150 to 100,000, and more preferably 600 to 20,000. When the weight-average molecular weight is 150 or more, the absorbability to the particles such as the component (A) is improved to improve particle dispersibility. When the weight-average molecular weight is 100,000 or less, aggregation between the particles can be suppressed, and particle dispersibility is improved. Polyallylamines having arbitrary weight-average molecular weights may be produced using the method described in Japanese Examined Patent Publication No. Hei. 2-14364 B.

As the polyallylamine, a commercially available product can be used. Examples of commercially available products of polyallylamine may include "PAA-01", "PAA-03", "PAA-05", "PAA-08", "PAA-15", "PAA-15C", and "PAA-25" that are manufactured by Nittobo Medical Co., Ltd.

The pH of the component (C) may usually be 4 or greater and less than 7. The pH can be measured according to the indicator method.
Specifically, the pH can be measured by immersing a pH test paper in a measuring sample (22°C), which is prepared by dissolving a dispersant in acetone and has a dispersant concentration 0.1 g/mL. As the pH test paper, a pH test paper capable of measuring a pH in an acidic region (for example, having a measurement region of a pH of 0.0 to 14.0, a pH of 1.0 to 14.0 or a pH of 0.5 to 5.0) can be used, and examples thereof may include a pH test paper "pH test paper pH 1 to 14" (pH measurement range: a pH of 1.0 to 14.0" manufactured by AS ONE Corporation.

The acid value of the component (C) is preferably 1 mgKOH/g or more, more preferably 3 mgKOH/g or more, and further preferably 5 mgKOH/g, and preferably 30 mgKOH/g or less, more preferably 25 mgKOH/g or less, and further preferably 20 mgKOH/g or less, from the viewpoint of significantly obtaining the advantageous effects of the present invention. The acid value can be measured by a neutralization titration method.

When the component (C) is a dispersant that has reacted with a polyallylamine, the amine value is preferably 1 mgKOH/g or more, more preferably 5 mgKOH/g or more, and further preferably 10 mgKOH/g or more, and preferably 45 mgKOH/g or less, more preferably 40 mgKOH/g or less, and further preferably 35 mgKOH/g or less, from the viewpoint of significantly obtaining the advantageous effects of the present invention. The amine value can be measured by a neutralization titration method.

The weight-average molecular weight of the component (C) is preferably 1,000 or more, more preferably 1,500 or more, and further preferably 2,000 or more, and preferably 50,000 or less, more preferably 40,000 or less, and further preferably 30,000 or less, from the viewpoint of significantly obtaining the advantageous effects of the present invention. The weight-average molecular weight is a polystyrene-equivalent weight-average molecular weight measured by a gel permeation chromatography (GPC) method.

The content of the component (C) is preferably 0.1% by mass or more, more preferably 0.2% by mass or more, and further preferably 0.3% by mass or more, and the upper limit is preferably 5% by mass or less, more preferably 3% by mass or less, and further preferably 1% by mass or less, when the nonvolatile component in the resin composition is defined as 100% by mass, from the viewpoint of significantly exhibiting the advantageous effects of the present invention.

Provided that the mass (% by mass) of the component (C) is defined as C1 when the nonvolatile component in the resin composition is defined as 100% by mass, and that the mass (% by mass) of the magnetic powder (A) is defined as A1 when the nonvolatile component in the resin composition is defined as 100% by mass, the value of (C1/A1) × 100 is preferably 0.1 or more, more preferably 0.2 or more, and further preferably 0.3 or more, and preferably 10 or less, more preferably 5 or less, and further preferably 1 or less. By adjusting the masses of the components (A) and (C) so that the value of (C1/A1) × 100 falls within such a range, it is possible to significantly obtain the desired advantageous effects of the present invention.

### -(D) Curing agent -

The resin composition includes a curing agent (D) as the component (D). The curing agent (D) includes an epoxy resin curing agent having a function of curing the epoxy resin (B), and a curing accelerator having a function of accelerating the curing rate of the epoxy resin (B). The curing accelerator is usually used in combination with an epoxy resin curing agent. The resin composition preferably contains an epoxy resin curing agent as the curing agent (D), and more preferably contains a curing accelerator together with the epoxy resin curing agent as the curing agent (D).

### (Epoxy resin curing agent)

The epoxy resin curing agent can generally react with the epoxy resin (B) to cure the resin composition. Examples of the epoxy resin curing agent may include a phenol-based epoxy resin curing agent, a naphthol-based epoxy resin curing agent, an active ester-based epoxy resin curing agent, an acid anhydride-based epoxy resin curing agent, a benzoxazine-based epoxy resin curing agent, a cyanate ester-based epoxy resin curing agent, and an imidazole-based epoxy resin curing agent. As the epoxy resin curing agent, one or more types selected from a phenol-based epoxy resin curing agent and a naphthol-based epoxy resin curing agent are preferable from the viewpoint of significantly obtaining the advantageous effects of the present invention. As the epoxy resin curing agent, one type thereof may be solely used, and two or more types thereof may also be used in combination.

As the phenol-based epoxy resin curing agent and the naphthol-based epoxy resin curing agent, a phenol-based epoxy resin curing agent having a novolac structure or a naphthol-based epoxy resin curing agent having a novolac structure is preferable from the viewpoint of heat resistance and water resistance. As the phenol-based epoxy resin curing agent, a nitrogen-containing phenol-based epoxy resin curing agent is preferable, a triazine skeleton-containing phenol-based epoxy resin curing agent is more preferable, and a triazine skeleton-containing phenol-based novolac epoxy resin curing agent is further preferable.

Specific examples of the phenol-based epoxy resin curing agent and the naphthol-based epoxy resin curing agent may include "MEH-7700", "MEH-7810", and "MEH-7851" manufactured by Meiwa Plastic Industries, Ltd., "NHN", "CBN", and "GPH" manufactured by Nippon Kayaku Co., Ltd., "SN170", "SN180", "SN190", "SN475", "SN485", "SN495V", "SN375", and "SN395" manufactured by Nippon Steel Chemical & Material Co., Ltd., "TD-2090", "LA-7052", "LA-7054", "LA-1356", "LA-3018-50P", "EXB-9500", "HPC-9500", "KA-1160", "KA-1163", and "KA-1165" manufactured by DIC Corp., and "GDP-6115L" and "GDP-6115H" manufactured by Gun Ei Chemical Industry Co., Ltd.

The active ester-based epoxy resin curing agent is not particularly limited, and generally a compound having two or more highly reactive ester groups in one molecule such as phenol esters, thiophenol esters, N-hydroxyamine esters, and esters of heterocyclic hydroxy compounds is preferably used. The active ester-based epoxy resin curing agent is preferably one obtained by a condensation reaction of a carboxylic acid compound and/or a thiocarboxylic acid compound with a hydroxy compound and/or a thiol compound. In particular, from the viewpoint of improving heat resistance, an active ester-based epoxy resin curing agent obtained from a carboxylic acid compound and a hydroxy compound is preferable, and an active ester-based epoxy resin curing agent obtained from a carboxylic acid compound and a phenol compound and/or a naphthol compound is more preferable. Examples of the carboxylic acid compound may include benzoic acid, acetic acid, succinic acid, maleic acid, itaconic acid, phthalic acid, isophthalic acid, terephthalic acid, and pyromellitic acid. Examples of the phenol compound or naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, a dicyclopentadiene type diphenol compound, and phenol novolac. Herein, the "dicyclopentadiene type diphenol compound" refers to a diphenol compound obtained by condensing two phenol molecules with one dicyclopentadiene molecule.

Specifically, an active ester-based epoxy resin curing agent containing a dicyclopentadiene type diphenol structure, an active ester-based epoxy resin curing agent containing a naphthalene structure, an active ester-based epoxy resin curing agent containing an acetylated product of phenol novolac, and an active ester-based epoxy resin curing agent containing a benzoylated product of phenol novolac are preferable. The "dicyclopentadiene type diphenol structure" refers to a divalent structure consisting of phenylene-dicyclopentylene-phenylene.

Examples of the commercially available active ester-based epoxy resin curing agent may include "EXB9451", "EXB9460", "EXB9460S", "HPC-8000-65T", "HPC-8000H-65TM", and "EXB-8000L-65TM" that are manufactured by DIC Corp. as an active ester-based epoxy resin curing agent containing a dicyclopentadiene type diphenol structure; "EXB9416-70BK" manufactured by DIC Corp. as an active ester compound containing a naphthalene structure; "DC808" manufactured by Mitsubishi Chemical Corporation as an active ester-based epoxy resin curing agent containing an acetylated product of phenol novolac; "YLH1026", "YLH1030" and "YLH1040" that are manufactured by Mitsubishi Chemical Co., Ltd. as an active ester-based epoxy resin curing agent containing a benzoylated product of phenol novolac; and "DC808" manufactured by Mitsubishi Chemical Corporation as an active ester-based epoxy resin curing agent which is an acetylated product of phenol novolac.

Examples of the acid anhydride-based epoxy resin curing agent may include epoxy resin curing agents having one or more acid anhydride groups within one molecule. Specific examples of the acid anhydride-based epoxy resin curing agent may include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyltetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenonetetracarboxylic dianhydride, biphenyltetracarboxylic dianhydride, naphthalenetetracarboxylic dianhydride, oxydiphthalic dianhydride, 3,3'-4,4'-diphenylsulfonetetracarboxylic dianhydride, 1,3,3a,4,5,9b-hexahydro-5-(tetrahydro-2,5-dioxo-3-furanyl)-naphtho[1,2-C]furan-1,3-dione, ethylene glycol bis(anhydrotrimellitate), and a polymer type acid anhydride such as an anhydride of a styrene-maleic acid resin in which styrene and maleic acid are copolymerized.

Examples of commercially available products of the acid anhydride-based epoxy resin curing agent may include "HNA-100" and "MH-700" manufactured by New Japan Chemical Co., Ltd.

Specific examples of the benzoxazine-based epoxy resin curing agent may include "HFB2006M" manufactured by Showa Highpolymer Co., Ltd., and "P-d" and "F-a" manufactured by Shikoku Chemicals Corp.

Examples of the cyanate ester-based epoxy resin curing agent may include difunctional cyanate resins such as bisphenol A dicyanate, polyphenol cyanate, oligo(3-methylene-1,5-phenylene cyanate), 4,4'-methylenebis(2,6-dimethylphenyl cyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl)ether; polyfunctional cyanate resins derived from phenol novolak and cresol novolac; and prepolymers obtained by partially triazinizing these cyanate resins as above. Specific examples of the cyanate ester-based epoxy resin curing agent may include "PT30" and "PT60" (both of which are phenol novolac type polyfunctional cyanate ester resins), and "BA230" and "BA230S75" (prepolymers in which part or all of bisphenol A dicyanate is triazinated to form a trimer), which are manufactured by LONZA K.K..

Examples of the imidazole-based epoxy resin curing agent may include imidazole compounds and adducts of an imidazole compound and an epoxy resin, such as 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline, with 2-ethyl-4-methylimidazole and 1-benzyl-2-phenylimidazole being preferable.

As the imidazole-based epoxy resin curing agent, a commercially available product may be used, and examples thereof may include "2MZA-PW" and "2PHZ-PW" manufactured by Shikoku Chemicals Corp., and "P200-H50" manufactured by Mitsubishi Chemical Corporation.

The amount ratio of the epoxy resin to the epoxy resin curing agent is preferably in a range of 1:0.2 to 1:2, more preferably in a range of 1:0.3 to 1:1.5, and further preferably in a range of 1:0.4 to 1:1 in terms of the ratio of [total number of epoxy groups of the epoxy resin] : [total number of reactive groups of the epoxy resin curing agent]. Herein, the reactive group of the epoxy resin curing agent is an active hydroxyl group, an active ester group, or the like, and varies depending on the type of the epoxy resin curing agent. The total number of the epoxy groups of the epoxy resin is a value obtained by dividing the mass of nonvolatile component of each epoxy resin by the epoxy equivalent and summing the resulting values for all epoxy resins. The total number of the reactive groups of the epoxy resin curing agent is a value obtained by dividing the mass of nonvolatile component of each epoxy resin curing agent by the reactive group equivalent and summing the resulting values for all epoxy resin curing agents. By adjusting the amount ratio of the epoxy resin to the epoxy resin curing agent to fall within such a range, heat resistance of the cured product is further improved.

The content of the epoxy resin curing agent is preferably 0.1% by mass or more, more preferably 0.5% by mass or more, and further preferably 1% by mass or more, and the upper limit is preferably 5% by mass or less, more preferably 4% by mass or less, and further preferably 3% by mass or less, when the nonvolatile component in the resin composition is defined as 100% by mass, from the viewpoint of significantly obtaining the advantageous effects of the present invention.

### (Curing accelerator)

The curing accelerator usually acts as a catalyst in the curing reaction of the epoxy resin (B) to accelerate the curing reaction. Examples of the curing accelerator may include an amine-based curing accelerator, an imidazole-based curing accelerator, a phosphorus-based curing accelerator, a guanidine-based curing accelerator, and a metal-based curing accelerator. The curing accelerator is preferably an amine-based curing accelerator, an imidazole-based curing accelerator, or a guanidine-based curing accelerator from the viewpoint of reducing the viscosity of the resin composition, and more preferably an imidazole-based curing accelerator from the viewpoint of further improving the mechanical strength of the obtained cured product. As the curing accelerator, one type thereof may be solely used, and two or more types thereof may also be used in combination. The curing accelerator is generally used in combination with the epoxy resin curing agent.

Examples of the amine-based curing accelerator may include trialkylamines such as triethylamine and tributylamine, 4-dimethylaminopyridine, benzyldimethylamine, 2,4,6,-tris(dimethylaminomethyl)phenol, and 1,8-diazabicyclo(5,4,0)-undecene, with 4-dimethylaminopyridine and 1,8- diazabicyclo(5,4,0)-undecene being preferable.

A commercially available product may be used as the amine-based curing accelerator, and examples thereof may include "PN-50", "PN-23", and "MY-25" manufactured by Ajinomoto Fine-Techno Co., Inc.

The imidazole-based curing accelerator is the same as the imidazole-based epoxy resin curing agent described above. When the imidazole-based epoxy resin curing agent is used in combination with another epoxy resin curing agent, the imidazole-based epoxy resin curing agent may function as a curing accelerator.

Examples of the phosphorus-based curing accelerator may include triphenylphosphine, a phosphonium borate compound, tetraphenylphosphonium tetraphenylborate, n-butylphosphonium tetraphenylborate, a tetrabutylphosphonium decanoic acid salt, (4-methylphenyl)triphenylphosphonium thiocyanate, tetraphenylphosphonium thiocyanate, and butyltriphenylphosphonium thiocyanate, with triphenylphosphine and tetrabutylphosphonium decanoic acid salt being preferable.

Examples of the guanidine-based curing accelerator may include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]deca-5-ene, 7-methyl-1,5,7-triazabicyclo[4.4.0]deca-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide, with dicyandiamide and 1,5,7-triazabicyclo[4.4.0]deca-5-ene being preferable.

Examples of the metal-based curing accelerator may include organometallic complexes or organometallic salts of metals such as cobalt, copper, zinc, iron, nickel, manganese, and tin. Specific examples of the organometallic complex may include an organocobalt complex such as cobalt (II) acetylacetonate, and cobalt (III) acetylacetonate, , an organocopper complex such as copper (II) acetylacetonate, an organozinc complex such as zinc (II) acetylacetonate, an organoiron complex such as iron (III) acetylacetonate, an organonickel complex such as nickel (II) acetylacetonate, and an organomanganese complex such as manganese (II) acetylacetonate. Examples of the organometallic salt may include zinc octylate, tin octylate, zinc naphthenate, cobalt naphthenate, tin stearate, and zinc stearate.

The content of the curing accelerator is preferably 0.001% by mass or more, more preferably 0.005% by mass or more, and further preferably 0.01% by mass or more, and the upper limit is preferably 1% by mass or less, more preferably 0.1% by mass or less, and further preferably 0.05% by mass or less, when the resin component in the resin composition is defined as 100% by mass, from the viewpoint of significantly obtaining the advantageous effects of the present invention.

The content of the curing agent (D) is preferably 0.1% by mass or more, more preferably 0.5% by mass or more, and further preferably 1% by mass or more, and the upper limit is preferably 5% by mass or less, more preferably 4% by mass or less, and further preferably 3% by mass or less, when the nonvolatile component in the resin composition is defined as 100% by mass, from the viewpoint of significantly obtaining the advantageous effects of the present invention.

Provided that the mass (% by mass) of the curing agent (D) is defined as D1 when the nonvolatile component in the resin composition is defined as 100% by mass, and that the mass (% by mass) of the dispersant (C) is defined as C1 when the nonvolatile component in the resin composition is defined as 100% by mass, C1/D1 is preferably 0.01 or more, more preferably 0.05 or more, and further preferably 0.1 or more, and preferably 5 or less, more preferably 1.5 or less, and further preferably 1 or less. By adjusting the masses of the components (C) and (D) so that C1/D1 falls within such a range, the desired advantageous effects of the present invention can be obtained more significantly.

Provided that the mass (% by mass) of the magnetic powder (A) is defined as A1 when the nonvolatile component in the resin composition is defined as 100% by mass, that the mass (mass%) of the epoxy resin is defined as B1 when the nonvolatile component in the resin composition is defined as 100% by mass, that the mass (% by mass) of the dispersant (C) is defined as C1 when the nonvolatile component in the resin composition is defined as 100% by mass, and that the mass (% by mass) of the curing agent (D) is defined as D1 when the nonvolatile component in the resin composition is defined as 100% by mass, (B1 + C1 + D1)/A1 is preferably 0.001 or more, more preferably 0.005 or more, and further preferably 0.01 or more, and preferably 1 or less, more preferably 0.5 or less, and further preferably 0.3 or less. By adjusting the masses of the components (A) to (D) so that (B1 + C1 + D1)/A1 falls within such a range, the desired advantageous effects of the present invention can be obtained more significantly.

Provided that the mass (% by mass) of the magnetic powder (A) is defined as A1 when the nonvolatile component in the resin composition is defined as 100% by mass, that the mass (% by mass) of the dispersant (C) is defined as C1 when the nonvolatile component in the resin composition is defined as 100% by mass, and that the mass (% by mass) of the curing agent (D) is defined as D1 when the nonvolatile component in the resin composition is defined as 100% by mass, ((C1 + D1)/A1) × 100 is preferably 0.1 or more, more preferably 0.5 or more, and further preferably 1 or more, and preferably 10 or less, more preferably 5 or less, and further preferably 3 or less. By adjusting the masses of the components (A), (C) and (D) so that ((C1 + D1)/A1) × 100 falls within such a range, the desired advantageous effects of the present invention can be obtained more significantly.

### - (E) Thermoplastic resin -

The resin composition includes a thermoplastic resin (E) as the component (E). When the component (E) is contained in the resin composition, the stress of the cured product of the resin composition layer is relaxed, so that the mechanical strength of the cured product can be improved.

Examples of the thermoplastic resin (E) may include a phenoxy resin, a polyvinyl acetal resin, a polyolefin resin, a polyimide resin, a polybutadiene resin, a polyamide-imide resin, a polyetherimide resin, a polysulfone resin, a polyether sulfone resin, a polyphenylene ether resin, a polyether ether ketone resin, and a polyester resin, with phenoxy resin being preferable. As the thermoplastic resin (E), one type thereof may be solely used, and two or more types thereof may also be used in combination.

Examples of the phenoxy resin may include a phenoxy resin having one or more types of skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The terminal of the phenoxy resin may be any functional group such as a phenolic hydroxyl group or an epoxy group. Specific examples of the phenoxy resin may include "1256" and "4250" (both of which are bisphenol A skeleton-containing phenoxy resins) manufactured by Mitsubishi Chemical Corporation; "YX8100" (bisphenol S skeleton-containing phenoxy resin) manufactured by Mitsubishi Chemical Corporation; "YX6954" (bisphenol acetophenone skeleton-containing phenoxy resin) manufactured by Mitsubishi Chemical Corporation; "FX280" and "FX293" manufactured by Nippon Steel Chemical & Material Co., Ltd.,; and "YL7500BH30", "YX6954BH30", "YX7553", "YX7553BH30", "YL7769BH30", "YL6794", "YL7213", "YL7290", "YL7482" and "YL7891BH30" manufactured by Mitsubishi Chemical Corporation.

Examples of the polyvinyl acetal resin may include a polyvinyl formal resin and a polyvinyl butyral resin, with a polyvinyl butyral resin being preferable. Examples of the polyvinyl acetal resin may include "Denka Butyral 4000-2", "Denka Butyral 5000-A", "Denka Butyral 6000-C", and "Denka Butyral 6000-EP" manufactured by Denka Company Limited; and Eslek BH series, BX series (e.g., BX-5Z), KS series (e.g., KS-1), BL series, and BM series manufactured by Sekisui Chemical Co., Ltd.

Examples of the polyolefin resin may include ethylene-based copolymer resins such as low-density polyethylene, ultra-low-density polyethylene, high-density polyethylene, an ethylene-vinyl acetate copolymer, an ethylene-ethyl acrylate copolymer, and an ethylene-methyl acrylate copolymer; and polyolefin-based polymers such as polypropylene and an ethylene-propylene block copolymer.

Specific examples of the polyimide resin may include "SLK-6100" manufactured by Shin-Etsu Chemical Co., Ltd., and "Rica Coat SN20" and "Rica Coat PN20" manufactured by New Japan Chemical Co., Ltd. Specific examples of the polyimide resin may include modified polyimides such as linear polyimides (polyimides described in Japanese Patent Application Laid-Open No. 2006-37083 A) and polyimides containing a polysiloxane skeleton (polyimides described in Japanese Patent Application Laid-Open No. 2002-12667 A and Japanese Patent Application Laid-Open No. 2000-319386 A) obtained by reacting a bifunctional hydroxyl group-terminated polybutadiene, a diisocyanate compound, and a tetrabasic acid anhydride.

Examples of the polybutadiene resin may include a hydrogenated polybutadiene skeleton-containing resin, a hydroxyl group-containing polybutadiene resin, a phenolic hydroxyl group-containing polybutadiene resin, a carboxy group-containing polybutadiene resin, an acid anhydride group-containing polybutadiene resin, an epoxy group-containing polybutadiene resin, an isocyanate group-containing polybutadiene resin, a urethane group-containing polybutadiene resin, and a polyphenylene ether-polybutadiene resin.

Specific examples of the polyamide-imide resin may include "Vylomax HR11NN" and "Vylomax HR16NN" manufactured by TOYOBO Co., Ltd. Specific examples of the polyamide-imide resin may include modified polyamide-imides such as "KS9100" and "KS9300" (polysiloxane skeleton-containing polyamide-imide) manufactured by Hitachi Chemical Co., Ltd.

Specific examples of the polyethersulfone resin may include "PES5003P" manufactured by Sumitomo Chemical Co., Ltd.

Specific examples of the polysulfone resin may include polysulfone "P1700" and "P3500" manufactured by Solvay Advanced Polymers Co., Ltd.

Specific examples of the polyphenylene ether resin may include "NORYL SA90" manufactured by SABIC. Specific examples of the polyetherimide resin may include "Ultem" manufactured by GE Co., Ltd.

Examples of the polycarbonate resin may include a hydroxy group-containing carbonate resin, a phenolic hydroxyl group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin may include "FPC0220" manufactured by Mitsubishi Gas Chemical Co., Inc., "T6002" and "T6001" (polycarbonate diol) manufactured by Asahi Kasei Chemicals Co., Ltd., and "C-1090", "C-2090", and "C-3090" (polycarbonate diol) manufactured by Kuraray Co., Ltd. Specific examples of the polyether ether ketone resin may include "Sumiploy K" manufactured by Sumitomo Chemical Co., Ltd.

Examples of the polyester resin may include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexane dimethyl terephthalate resin.

The weight-average molecular weight (Mw) of the thermoplastic resin (E) is preferably greater than 5,000, more preferably 8,000 or more, further preferably 10,000 or more, and particularly preferably 20,000 or more. The upper limit is not particularly limited, and may be, for example, 1 million or less, 0.5 million or less, and 0.1 million or less. A polystyrene-equivalent weight-average molecular weight of the thermoplastic resin (E) is measured by a gel permeation chromatography (GPC) method. Specifically, the polystyrene-equivalent weight-average molecular weight of the thermoplastic resin (E) can be obtained by performing measurement at the column temperature of 40°C using LC-9A/RID-6A manufactured by Shimadzu Corporation as a measuring device, using Shodex K-800P/K-804L/K-804L manufactured by Showa Denko Co., Ltd as columns, and using chloroform or the like as a mobile phase, and performing calculation using a standard curve of the standard polystyrene.

The content of the thermoplastic resin (E) is preferably 0.1% by mass or more, more preferably 0.2% by mass or more, and particularly preferably 0.3% by mass or more, and preferably 5% by mass or less, more preferably 3% by mass or less, and particularly preferably 2% by mass or less, relative to 100% by mass of the nonvolatile component of the resin composition. When the amount of the thermoplastic resin (E) falls within the above-described range, the magnetic properties of the cured product of the resin composition can be particularly improved.

Provided that the mass (% by mass) of the thermoplastic resin (E) is defined as E1 when the nonvolatile component in the resin composition is defined as 100% by mass, and that the mass (% by mass) of the epoxy resin (B) is defined as B1 when the nonvolatile component in the resin composition is defined as 100% by mass, B1/E1 is preferably 0.1 or more, more preferably 0.3 or more, and further preferably 0.5 or more, and preferably 5 or less, more preferably 1.5 or less, and further preferably 1 or less. By adjusting the masses of the components (B) and (E) so that B1/E1 falls within such a range, the desired advantageous effects of the present invention can be obtained more significantly.

Provided that the mass (% by mass) of the thermoplastic resin (E) is defined as E1 when the nonvolatile component in the resin composition is defined as 100% by mass, and that the mass (% by mass) of the dispersant (C) is defined as C1 when the nonvolatile component in the resin composition is defined as 100% by mass, C1/E1 is preferably 0.01 or more, more preferably 0.05 or more, and further preferably 0.1 or more, and preferably 5 or less, more preferably 1.5 or less, and further preferably 1 or less. By adjusting the masses of the components (C) and (E) so that C1/E1 falls within such a range, the desired advantageous effects of the present invention can be obtained more significantly.

Provided that the mass (% by mass) of the magnetic powder (A) is defined as A1 when the nonvolatile component in the resin composition is defined as 100% by mass, that the mass (% by mass) of the epoxy resin (B) is defined as B1 when the nonvolatile component in the resin composition is defined as 100% by mass, that the mass (% by mass) of the dispersant (C) is defined as C1 when the nonvolatile component in the resin composition is defined as 100% by mass, that the mass (% by mass) of the curing agent (D) is defined as D1 when the nonvolatile component in the resin composition is defined as 100% by mass, and that the mass (% by mass) of the thermoplastic resin (E) is defined as E1 when the nonvolatile component in the resin composition is defined as 100% by mass, (B1 + C1 + D1 + E1)/A1 is preferably 0.001 or more, more preferably 0.01 or more, and further preferably 0.05 or more, and preferably 1 or less, more preferably 0.5 or less, and further preferably 0.3 or less. By adjusting the masses of the components (A) to (E) so that (B1 + C1 + D1 + E1)/A1 falls within such a range, the desired advantageous effects of the present invention can be obtained more significantly.

Provided that the mass (% by mass) of the magnetic powder (A) is defined as A1 when the nonvolatile component in the resin composition is defined as 100% by mass, that the mass (% by mass) of the dispersant (C) is defined as C1 when the nonvolatile component in the resin composition is defined as 100% by mass, and that the mass (% by mass) of the thermoplastic resin (E) when the nonvolatile component in the resin composition is defined as is defined as E1, ((C1 + E1)/A1) × 100 is preferably 0.1 or more, more preferably 0.5 or more, and further preferably 1 or more, and preferably 10 or less, more preferably 5 or less, and further preferably 3 or less. By adjusting the masses of the components (A), (C) and (E) so that ((C1 + E1)/A1) × 100 falls within such a range, the desired advantageous effects of the present invention can be obtained more significantly.

### - (F) Other additive -

The resin composition may further include other additives (F), if necessary. Examples of such other additives may include a curing retarder such as triethyl borate; an inorganic filler (excluding those corresponding to a magnetic powder); a flame retardant; an organic filler; an organometallic compound such as an organocopper compound, an organozinc compound, and an organocobalt compound; and resin additives such as a thickener; a defoaming agent; a leveling agent; an adhesion imparting agent; and a colorant.

### - (G) Solvent -

The resin composition may further include a solvent (G) as a volatile component in combination with nonvolatile components such as the components (A) to (F) described above.

As the solvent (G), an organic solvent is usually used. Examples of the organic solvent may include ketone-based solvents such as acetone, methyl ethyl ketone, methyl isobutyl ketone, and cyclohexanone; ester-based solvents such as methyl acetate, ethyl acetate, butyl acetate, isobutyl acetate, isoamyl acetate, methyl propionate, ethyl propionate, and γ-butyrolactone; ether-based solvents such as tetrahydropyran, tetrahydrofuran, 1,4-dioxane, diethyl ether, diisopropyl ether, dibutyl ether, and diphenyl ether; alcohol-based solvents such as methanol, ethanol, propanol, butanol, and ethylene glycol; ether-ester-based solvents such as 2-ethoxyethyl acetate, propylene glycol monomethyl ether acetate, diethylene glycol monoethyl ether acetate, ethyl diglycol acetate, γ-butyrolactone, and methyl methoxypropionate; ester alcohol-based solvents such as methyl lactate, ethyl lactate, and methyl 2-hydroxyisobutyrate; ether alcohol-based solvents such as 2-methoxypropanol, 2-methoxyethanol, 2-ethoxyethanol, propylene glycol monomethyl ether, and diethylene glycol monobutyl ether (butyl carbitol); amide-based solvents such as N,N-dimethylformamide, N,N-dimethylacetamide, and N-methyl-2-pyrrolidone; sulfoxide-based solvents such as dimethyl sulfoxide; nitrile-based solvents such as acetonitrile and propionitrile; aliphatic hydrocarbon-based solvents such as hexane, cyclopentane, cyclohexane, and methylcyclohexane; and aromatic hydrocarbon-based solvents such as benzene, toluene, xylene, ethylbenzene, and trimethylbenzene. As the solvent (G), one type thereof may be solely used, and two or more types thereof may also be used in combination.

The amount of the solvent (G) is preferably set so that the melt viscosity of the resin composition or the resin composition layer containing the resin composition can be adjusted within an appropriate range. Furthermore, the resin composition may not contain the solvent (G). For example, the content of the organic solvent contained in the resin composition described above is preferably less than 1.0% by mass, more preferably 0.8% by mass or less, further preferably 0.5% by mass or less, and particularly preferably 0.1% by mass or less, relative to the total mass of the resin composition. The lower limit is not particularly limited, and is 0.001% by mass or more, or is not contained. When the amount of the solvent in the resin composition is small, generation of voids due to volatilization of the solvent can be suppressed.

The thickness of the resin composition layer depends on the thickness of the wiring, the thickness of the core substrate, and the dimensions of the through hole, and is preferably 5 µm or more, more preferably 10 µm or more, and particularly preferably 50 µm or more, and preferably 600 µm or less, more preferably 300 µm or less, and particularly preferably 200 µm or less.

### <Production method of resin sheet>

A resin sheet can be produced, for example, by a method including applying a resin composition onto a support. Furthermore, a resin composition layer can be produced, for example, by preparing a resin varnish in which the resin composition is dissolved or dispersed in a solvent, applying this resin varnish onto the support using a die coater or the like, and then drying the resin varnish. Note that the resin composition layer can also be produced by directly applying the resin composition onto the support using a die coater or the like. As the solvent, the above-mentioned solvent (G) can be used.

Drying may be performed by a known method such as heating or blowing hot air. Drying conditions are not particularly limited, and drying is performed so that the content of the organic solvent in the resin composition layer becomes 10% by mass or less, preferably 5% by mass or less. Although this depends on the boiling point of the organic solvent in the resin varnish, for example, when the resin varnish including 30% by mass to 60% by mass of the organic solvent is used, the resin composition layer can be formed by drying the resin varnish at 50°C to 150°C for 3 to 10 minutes.

In the resin sheet, a protective film suitable for the support can be further laminated on the surface of the resin composition layer that is not bonded to the support (i.e., the surface opposite to the support). The thickness of the protective film is not particularly limited, and the thickness is, for example, 1 µm to 40 µm. Laminating the protective film can prevent adhesion of dust or the like and scratches to the surface of the resin composition layer. The resin sheet can be rolled up and stored. When the resin sheet includes the protective film, the resin sheet can be used by peeling off the protective film.

### <Physical properties, etc. of resin composition layer (resin composition)>

A cured product obtained by heating the resin composition layer (resin composition) at 190°C for 90 minutes exhibits excellent mechanical strength (tensile strength at break). Thus, the cured product yields a magnetic layer with excellent tensile strength at break. The tensile strength at break is preferably 60 MPa or more, more preferably 70 MPa or more, and further preferably 75 MPa or more. The upper limit is not particularly limited, and it can be, for example, 150 MPa or less. The mechanical strength (tensile strength at break) can be measured by the method described in Examples below.

The cured product obtained by heating the resin composition layer (resin composition) at 190°C for 90 minutes exhibits a high relative permeability at a frequency of 50 MHz. Thus, the cured product yields a magnetic layer with a high relative permeability. The relative permeability of this cured product at a frequency of 50 MHz is preferably 20 or more, more preferably 20.5 or more, further preferably 21 or more. Furthermore, the upper limit is not particularly limited, and it can be, for example, 100 or less. The relative permeability can be measured by the method described in Examples below.

The cured product obtained by heating the resin composition layer (resin composition) at 190°C for 90 minutes usually exhibits low magnetic loss at a frequency of 50 MHz. Thus, the cured product yields a magnetic layer with low magnetic loss. The magnetic loss of this cured product at a frequency of 50 MHz is preferably 0.5 or less, more preferably 0.3 or less, and further preferably 0.1 or less. The lower limit is not particularly limited, and it can be, for example, 0.001 or more. The magnetic loss can be measured by the method described in Examples below.

From the viewpoint of utilizing the above-mentioned advantages of the resin sheet, the resin composition layer (resin composition) is preferably used for forming a magnetic layer of a circuit board. Furthermore, from the viewpoint of utilizing the above-mentioned advantages of the resin sheet, the resin composition layer (resin composition) is preferably used for filling a through hole of a core substrate. When the core substrate and the resin sheet are laminated, a part or all of the resin composition layer enters a through hole, so that the through hole can be filled with the resin composition. Then, the resin composition is cured to form a magnetic layer in the through hole.

### [Resin composition]

The resin composition of the present invention includes a magnetic powder (A), an epoxy resin (B), a dispersant (C), a curing agent (D), and a thermoplastic resin (E). Provided that the mass (% by mass) of the thermoplastic resin (E) is defined as E1 when the nonvolatile component in the resin composition is defined as 100% by mass, and that the mass (% by mass) of the epoxy resin (B) is defined as B1 when the nonvolatile component in the resin composition is defined as 100% by mass, B1/E1 is 0.1 or more and 5 or less. The component (C) has a polyester skeleton represented by the following general formula (1). 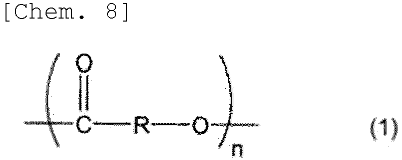 (in the general formula (1), Rs each independently represent a hydrocarbon group of 2 to 10 carbon atoms, and n represents an integer of 2 to 1,000)

The resin composition can be the same composition as that of the resin composition layer described above, except that the resin composition may be in a state other than the state of the resin composition layer formed on the sheet. Each component included in the resin composition is as described above.

### [Cured product]

The cured product of the present invention is obtained by curing the resin composition layer of the present invention. Furthermore, the cured product of the present invention is obtained by curing the resin composition of the present invention. For the curing conditions of the resin composition layer and the resin composition, the conditions of the step (2) described below may be used. Furthermore, before the resin composition layer and the resin composition are heat-cured, preheating may be performed, and heating may be performed multiple times including preheating.

### [Circuit board and production method thereof]

A circuit board according to an embodiment of the present invention includes a magnetic layer. This magnetic layer includes the cured product of the resin composition layer of the resin sheet described above, and preferably includes only the cured product of the resin composition described above. The specific structure of the circuit board is not limited as long as the circuit board includes the magnetic layer including the cured product of the resin composition layer described above. The circuit board of a first embodiment is a circuit board that includes a core substrate as a substrate in which a through hole has been formed, and a magnetic layer filled in the through hole. Furthermore, the circuit board of a second embodiment is a circuit board that includes the magnetic layer formed of the cured product of the resin composition layer of the resin sheet. In these circuit boards, the magnetic layer can be a layer obtained by curing the resin composition layer or a layer obtained by curing the resin composition. Hereinafter, the first embodiment and the second embodiment of a method for producing the circuit board are described. However, the method for producing the circuit board according to the present invention is not limited to the first and second embodiments illustrated below.

### <First embodiment>

The circuit board of the first embodiment includes a core substrate in which a through hole has been formed, and a magnetic layer filled in the through hole. This circuit board producing method includes, for example:
(1) a step of laminating the core substrate in which the through hole has been formed and the resin sheet so that the through hole is filled with the resin composition layer; and
(2) a step of curing the resin composition layer to form the magnetic layer, in this order.
   Furthermore, the method for producing the circuit board of the first embodiment may include an optional step in combination with the above-mentioned steps (1) and (2). For example, the method for producing the circuit board may include:
(3) a step of polishing the magnetic layer;
(4) a step of subjecting the magnetic layer to a roughening treatment; and
(5) a step of forming a conductor layer on the magnetic layer. The step (3), the step (4), and the step (5) are usually performed in this order.

### <Step (1)>

The step (1) usually includes a step of preparing the core substrate in which the through hole has been formed. The core substrate may be prepared by purchasing it from the market. Furthermore, the core substrate may be prepared by producing it using suitable materials. Hereinbelow, a method for producing the core substrate according to an example will be described.

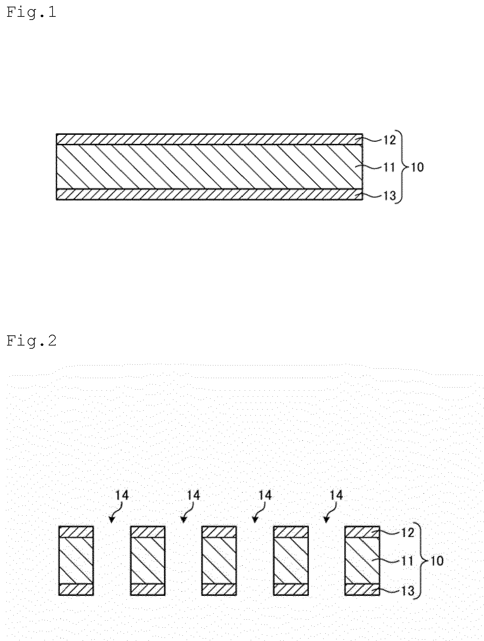

FIG. 1 is a cross-sectional view schematically showing a core substrate 10 before a through-hole is formed in the method for producing the circuit board according to the first embodiment of the present invention. The step of preparing the core substrate 10 may include preparing the core substrate 10 in which the through hole to be filled with the magnetic layer is not formed, as shown in an example in FIG. 1. This core substrate 10 is a substrate before the through-hole is formed, and can be a plate-shaped member.

The core substrate 10 usually includes a supporting substrate 11. Examples of the supporting substrate 11 may include an insulating substrate such as a glass epoxy substrate, a metal substrate, a polyester substrate, a polyimide substrate, a BT resin substrate, and a thermosetting polyphenylene ether substrate.
Furthermore, a metal layer may be provided on the supporting substrate 11. The metal layer may be provided on one side or both sides of the supporting substrate 11. Herein, an example is shown in which metal layers 12 and 13 are provided on respective surfaces of the supporting substrate 11. Examples of the metal layers 12 and 13 include a layer formed of metal such as copper. The metal layers 12 and 13 may be, for example, a copper foil such as a carrier-supported copper foil, or a metal layer formed of a material for the conductor layer described below.

FIG. 2 is a cross-sectional view schematically showing the core substrate 10 in which through holes 14 have been formed in the method for producing the circuit board according to the first embodiment of the present invention. A step of preparing the core substrate 10 may include forming the through holes 14 in the core substrate 10, as shown in an example in FIG. 2. The through holes 14 can be formed by a method such as, for example, drilling processing, laser irradiation, plasma irradiation, or the like. The through holes 14 can be usually formed by forming penetration holes in the core substrate 10. As a specific example, the through holes 14 can be formed using a commercially available drilling device. Examples of the commercially available drilling device may include "ND-1S211" manufactured by Hitachi Via Mechanics, Ltd.

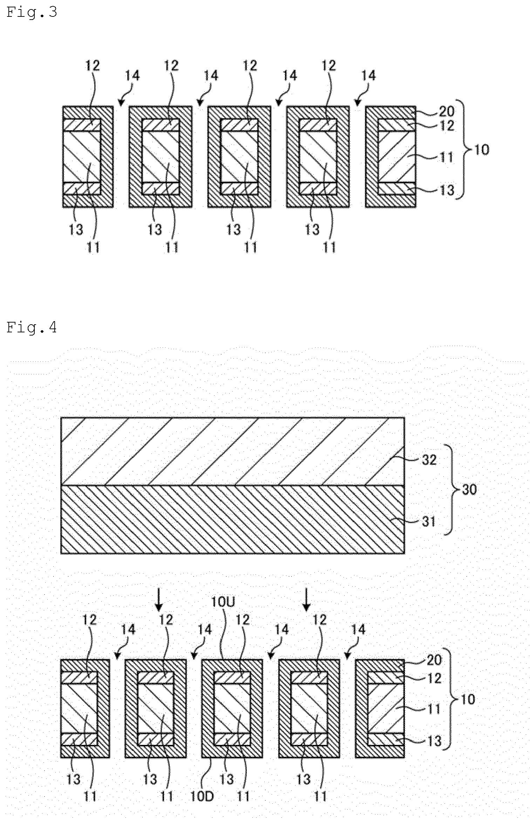

FIG. 3 is a cross-sectional view schematically showing the core substrate 10 in which a plating layer 20 has been formed in the through holes 14 in the method for producing the circuit board according to the first embodiment of the present invention. The step of preparing the core substrate 10 may include, after subjecting the core substrate 10 to a roughening treatment as necessary, forming the plating layer 20 as shown in FIG. 3. As the roughening treatment described above, either dry or wet roughening treatment may be performed. Examples of the dry roughening treatment may include a plasma treatment. Furthermore, examples of the wet roughening treatment may include a method in which a swelling treatment with a swelling liquid, a roughening treatment with an oxidizing agent, and a neutralizing treatment with a neutralizing liquid are performed in this order. The plating layer 20 can be formed by a plating method. The procedure for forming the plating layer 20 by the plating method can be the same as the procedure for forming the conductor layer in the step (5) described below. Herein, an example is shown in which the plating layer 20 is formed in the through holes 14, on the surface of the metal layer 12, and on the surface of the metal layer 13. Furthermore, in the description of this example, the core substrate provided with the plating layer 20 is given the same reference sign "10" as the core substrate 10 before the plating layer 20 is formed.

FIG. 4 is a cross-sectional view schematically showing how the core substrate 10 and a resin sheet 30 are laminated in the method for producing the circuit board according to the first embodiment of the present invention. The step (1) includes, after preparing the core substrate 10 in which the through holes 14 have been formed, laminating the core substrate 10 and the resin sheet 30, as shown in FIG. 4. In the present embodiment, an example is described in which the resin sheet 30 including a resin composition layer 31 and a support 32 is laminated on one surface 10U of the core substrate 10. In the following description, between the surfaces of the core substrate 10, the surface 10U to be bonded to the resin sheet 30 may be referred to as a "first surface 10U", and the opposite surface may be referred to as a "second surface 10D".

The core substrate 10 and the resin sheet 30 are laminated so that the through holes 14 are filled with a part or all of the resin composition layer 31. Thus, lamination is usually performed so that the resin composition layer 31 and the core substrate 10 are bonded to each other. Specifically, the lamination can be performed by heat-pressing the resin sheet 30 to the core substrate 10, thereby bonding the resin composition layer 31 to the core substrate 10. When the resin sheet 30 includes the support 32 as shown in an example in FIG. 4, the lamination can be performed by pressing the resin sheet 30 to the core substrate 10 from a side of the support 32. Examples of a member used for heat-pressing (hereinafter also referred to as a "heat-pressing member", not shown) may include a heated metal plate (a SUS mirror plate, etc.) and a metal roll (a SUS roll, etc.). Although the heat-pressing member may be directly pressed to the resin sheet 30, the heat-pressing member is preferably pressed through an elastic material such as heat-resistant rubber so that the resin sheet 30 sufficiently follows the surface irregularities of the core substrate 10.

The core substrate 10 and the resin sheet 30 may be laminated, for example, by a vacuum lamination method. The lamination conditions can be, for example, as follows. The heat-pressing temperature is in a range of preferably 60°C to 160°C, and more preferably 80°C to 140°C. The heat-pressing pressure is in a range of preferably 0.098 MPa to 1.77 MPa, and more preferably 0.29 MPa to 1.47 MPa. The heat-pressing time is in a range of preferably 20 seconds to 400 seconds, and more preferably 30 seconds to 300 seconds. The lamination is preferably performed under reduced pressure conditions with a pressure of 13 hPa or lower.

After the lamination, the laminated resin sheet 30 may be subjected to a smoothing treatment under normal pressure (atmospheric pressure), for example, by pressing the heat-pressing member from the support 32 side. The pressing conditions for the smoothing treatment can be the same as the heat-pressing conditions for the lamination described above. Note that the lamination and the smoothing treatment may be performed continuously using a vacuum laminator.

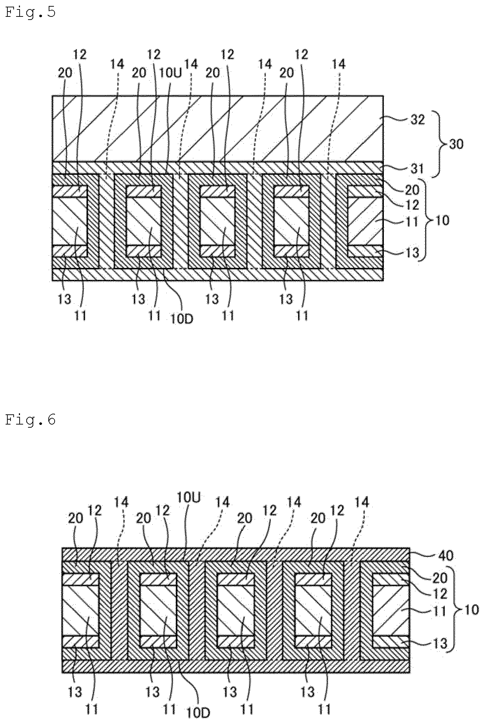

FIG. 5 is a cross-sectional view schematically showing a state in which the core substrate 10 and the resin sheet 30 are laminated in the method for producing the circuit board according to the first embodiment of the present invention. When the core substrate 10 and the resin sheet 30 are laminated, as shown in FIG. 5, the resin composition layer 31 of the resin sheet 30 enters the through holes 14, thus the through holes 14 are filled with the resin composition layer 31. Herein, an example is described in which a part of the resin composition layer 31 enters the through holes 14, and another part not entering the through holes 14 adheres to the first surface 10U of the core substrate 10. As a result, the resin composition layer 31 can be formed on the first surface 10U of the core substrate 10. Furthermore, yet another part of the resin composition layer 31 that has entered the through holes 14 can pass through the through holes 14 and be discharged from openings on a side of the second surface 10D of the core substrate 10. Thus, the resin composition layer 31 can be formed on the second surface 10D of the core substrate 10.

Usually, the support 32 is peeled off after the core substrate 10 and the resin sheet 30 are laminated. In the present embodiment, an example is described in which the support 32 is peeled off after the core substrate 10 and the resin sheet 30 are laminated but before the step (2). However, the support 32 may be peeled off after the step (2).

### <Step (2)>

FIG. 6 is a schematic cross-sectional view for explaining the step (2) in the method for producing the circuit board according to the first embodiment of the present invention. The step (2) includes, after laminating the core substrate 10 and the resin sheet 30, curing the resin composition layer 31, as shown in FIG. 6. Curing the resin composition layer 31 can form a magnetic layer 40 including a cured product of the resin composition. The magnetic layer 40 is formed in the through holes 14, and usually the magnetic layer 40 can also be formed on the first surface 10U and the second surface 10D of the core substrate 10.

The resin composition layer 31 is usually cured by heat curing. The heat curing conditions for the resin composition layer 31 can be appropriately set within a range in which curing of the resin composition layer 31 proceeds. The curing temperature is preferably 60°C or higher, more preferably 70°C or higher, and further preferably 80°C or higher, and preferably 245°C or lower, more preferably 220°C or lower, and further preferably 200°C or lower. The curing time is preferably 5 minutes or longer, more preferably 10 minutes or longer, and further preferably 15 minutes or longer, and preferably 120 minutes or shorter, more preferably 110 minutes or shorter, and further preferably 100 minutes or shorter.

A curing degree of the magnetic layer 40 obtained in the step (2) is preferably 80% or more, more preferably 85% or more, and further preferably 90% or more. The curing degree can be measured using, for example, a differential scanning calorimeter.

The method for producing the circuit board may include a step of heating the resin composition layer 31 at a temperature lower than the curing temperature (preheating step) after the core substrate 10 and the resin sheet 30 are laminated but before the resin composition layer 31 is cured. For example, before curing the resin composition layer 31, the resin composition layer 31 may be preheated at a temperature of usually 50°C or higher and lower than 120°C (preferably 60°C or higher and 110°C or lower, more preferably 70°C or higher and 100°C or lower) for usually 5 minutes or longer (preferably 5 minutes to 150 minutes, more preferably 15 minutes to 120 minutes).

### <Step (3)>

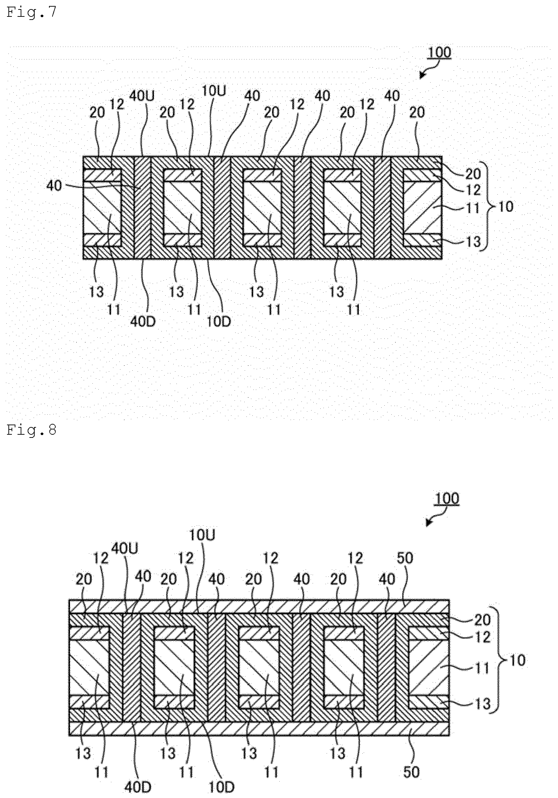

FIG. 7 is a schematic cross-sectional view for explaining the step (3) in the method for producing the circuit board according to the first embodiment of the present invention. The step (3) may include polishing the magnetic layer 40. Specifically, the step (3) may include polishing a part of the magnetic layer 40 outside the through holes 14. In the example shown in the present embodiment, the magnetic layer 40 is formed on the first surface 10U and the second surface 10D of the core substrate 10. Thus, the part of the magnetic layer 40 present on the first surface 10U and the second surface 10D can be polished. The part of the magnetic layer 40 outside the through holes 14 is generally an excess part that is not needed in the final product. Such an excess part can be removed by the polishing described above as shown in FIG. 7. Furthermore, by polishing, polished surfaces 40U and 40D can be flattened as the surfaces of the magnetic layer 40.

As a polishing method, a method that can remove the unnecessary part of the magnetic layer 40 can be adopted. Examples of such a polishing method may include buff polishing, belt polishing, and ceramic polishing. Examples of a commercially available buff polishing device may include "NT-700IM" manufactured by Ishiihyoki Co., Ltd.

The arithmetic average roughness (Ra) of the polished surfaces 40U and 40D of the magnetic layer 40 is preferably 300 nm or more, more preferably 350 nm or more, and further preferably 400 nm or more, from the viewpoint of improving adhesion with the conductor layer (not shown in FIG. 7). The upper limit is preferably 1,000 nm or less, more preferably 900 nm or less, and further preferably 800 nm or less. The surface roughness (Ra) can be measured using, for example, a non-contact surface roughness meter.

After the step (2) but before the step (3), the magnetic layer 40 may be subjected to a heat treatment in order to further increase the curing degree of the magnetic layer 40. The temperature in the heat treatment can be similar to the curing temperature described above. The specific heat treatment temperature is preferably 120°C or higher, more preferably 130°C or higher, and further preferably 150°C or higher, and preferably 245°C or lower, more preferably 220°C or lower, and further preferably 200°C or lower. The heat treatment time is preferably 5 minutes or longer, more preferably 10 minutes or longer, and further preferably 15 minutes or longer, and preferably 150 minutes or shorter, more preferably 120 minutes or shorter, and further preferably 100 minutes or shorter.

When the steps (1) and (2) described above are performed, and the step (3) is further performed as necessary, it is possible to obtain a circuit board 100 that includes the core substrate 10 and the magnetic layer 40 with which the through holes 14 of the core substrate 10 are filled. The circuit board 100 thus obtained may be, if necessary, subjected to the step (4) and the step (5) to form the conductor layer.

### <Step (4)>

The step (4) includes performing a roughening treatment to the magnetic layer. The roughening treatment is usually applied to the polished surface of the magnetic layer. Furthermore, in the step (4), the roughening treatment may be applied to not only the polished surface of the magnetic layer but also the surfaces 10U and 10D of the core substrate 10.

The procedure and conditions for the roughening treatment are not particularly limited, and for example, the procedure and conditions used in a method for producing a multilayer printed wiring board may be adopted. As a specific example, the roughening treatment may be performed by a method including a swelling treatment with a swelling liquid, a roughening treatment with an oxidizing agent, and a neutralizing treatment with a neutralizing liquid in this order.

Examples of the swelling liquid used in the swelling treatment may include an alkaline solution and a surfactant solution, with an alkaline solution being preferable. As the alkaline solution serving as the swelling liquid, a sodium hydroxide solution and a potassium hydroxide solution are more preferable. Examples of a commercially available swelling liquid may include "SWELLING DIP SECURIGANTH P" and "SWELLING DIP SECURIGANTH SBU" manufactured by Atotech Japan K.K.

The swelling treatment with the swelling liquid can be performed, for example, by immersing the magnetic layer in the swelling liquid at 30°C to 90°C for 1 minute to 20 minutes. From the viewpoint of reducing the swelling of the resin included in the magnetic layer to an appropriate level, the magnetic layer is preferably immersed in the swelling liquid at 40°C to 80°C for 5 minutes to 15 minutes.

Examples of the oxidizing agent used in the roughening treatment may include an alkaline permanganate solution in which potassium permanganate or sodium permanganate is dissolved in an aqueous solution of sodium hydroxide. The roughening treatment with the oxidizing agent such as the alkaline permanganate solution is preferably performed by immersing the magnetic layer in a solution of the oxidizing agent heated to 60°C to 80°C for 10 minutes to 30 minutes. Furthermore, the concentration of permanganate in the alkaline permanganate solution is preferably 5% by mass to 10% by mass. Examples of a commercially available oxidizing agent may include alkaline permanganate solutions such as "CONCENTRATE COMPACT P" and "DOSING SOLUTION SECURIGANTH P" manufactured by Atotech Japan K.K.

As the neutralizing liquid that can be used for the neutralizing treatment, an acidic aqueous solution is preferable. Examples of a commercially available neutralizing liquid may include "REDUCTION SOLUTION SECURIGANTH P" manufactured by Atotech Japan K.K. The neutralizing treatment with the neutralizing liquid can be performed by immersing the treated surface that has been subjected to the roughening treatment with the oxidizing agent solution in the neutralizing liquid at 30°C to 80°C for 5 minutes to 30 minutes. From the viewpoint of workability or the like, a method is preferable in which the magnetic layer that has been subjected to the roughening treatment with the oxidizing agent solution is immersed in the neutralizing liquid at 40°C to 70°C for 5 minutes to 20 minutes.

The arithmetic average roughness (Ra) of the surface of the magnetic layer after the roughening treatment is preferably 300 nm or more, more preferably 350 nm or more, and further preferably 400 nm or more, from the viewpoint of improving the adhesion with the conductor layer. The upper limit is preferably 1,500 nm or less, more preferably 1,200 nm or less, and further preferably 1,000 nm or less. The surface roughness (Ra) can be measured using, for example, a non-contact surface roughness meter.

### <Step (5)>

FIG. 8 is a schematic cross-sectional view for explaining the step (5) in the method for producing the circuit board 100 according to the first embodiment of the present invention. The step (5) includes forming a conductor layer 50 on the polished surfaces 40U and 40D of the magnetic layer 40, as shown in FIG. 8. In the present embodiment, an example is shown in which the conductor layer 50 is formed not only on the polished surfaces 40U and 40D of the magnetic layer 40 but also on their surrounding surfaces (e.g., the first surface 10U and the second surface 10D of the core substrate 10). Furthermore, although FIG. 8 shows the example in which the conductor layers 50 are formed on both sides of the core substrate 10, the conductor layer 50 may be formed only on one side of the core substrate 10.

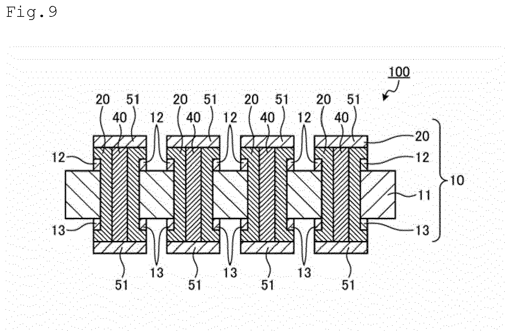

FIG. 9 is a schematic cross-sectional view for explaining the step (5) in the method for producing the circuit board 100 according to the first embodiment of the present invention. As shown in FIG. 9, the step (5) may include, after forming the conductor layer 50, removing parts of the conductor layer 50, the metal layers 12 and 13, and the plating layer 20 by a treatment such as etching to form a patterned conductor layer 51.

Examples of a method for forming the conductor layer 50 may include a plating method, a sputtering method, and a vapor deposition method, with a plating method being preferable. In a preferable embodiment, the patterned conductor layer 51 having a desired wiring pattern can be formed by plating the surface of the magnetic layer 40 (and, if necessary, the core substrate 10) by an appropriate method such as a semi-additive method or a fully-additive method. Examples of a material for the conductor layer 50 may include: a single metal such as gold, platinum, palladium, silver, copper, aluminum, cobalt, chromium, zinc, nickel, titanium, tungsten, iron, tin, and indium; and an alloy of two or more types of metals selected from the group consisting of gold, platinum, palladium, silver, copper, aluminum, cobalt, chromium, zinc, nickel, titanium, tungsten, iron, tin, and indium. Among these, from the viewpoint of versatility, costs, ease of patterning, and the like, chromium, nickel, titanium, aluminum, zinc, gold, palladium, silver, or copper, or a nickel-chromium alloy, a copper-nickel alloy, or a copper-titanium alloy is preferably used, chromium, nickel, titanium, aluminum, zinc, gold, palladium, silver, or copper, or a nickel-chromium alloy is more preferably used, and copper is further preferably used.

An example of a method for forming the patterned conductor layer 51 is described in detail. A plating seed layer is formed on the polished surfaces 40U and 40D of the magnetic layer 40 by electroless plating. Next, after forming a mask pattern as necessary on the plating seed layer thus formed, an electrolytic plating layer is formed by electrolytic plating. Then, if necessary, the mask pattern is removed, and then the unnecessary plating seed layer is further removed by a treatment such as etching, so that the patterned conductor layer 51 having a desired wiring pattern can be formed. After forming the patterned conductor layer 51, an annealing treatment may be performed if necessary in order to improve the adhesion strength of the patterned conductor layer 51. The annealing treatment can be performed, for example, by heating at 150°C to 200°C for 20 minutes to 90 minutes.

The thickness of the patterned conductor layer 51 is preferably 1 µm or more, more preferably 3 µm or more, and further preferably 5 µm or more, and preferably 70 µm or less, more preferably 50 µm or less, further preferably 40 µm or less, and particularly preferably 10 µm or less.

By the method described above, the circuit board 100 including the magnetic layer 40 is obtained. Since the magnetic layer 40 is obtained by curing the resin composition layer 31, the magnetic layer 40 includes the cured product of the resin composition. Thus, the magnetic layer 40 can include a large amount of the magnetic powders (not shown) and thus exhibit excellent magnetic properties.

### <Second embodiment>

The circuit board of the second embodiment includes a magnetic layer formed of a cured product of a resin composition layer of a resin sheet. This circuit board producing method includes, for example,
(A) a step of laminating the resin sheet on an inner layer substrate so that the resin composition layer is bonded to the inner layer substrate to form the magnetic layer.
   Furthermore, the method for producing the circuit board of the second embodiment may include an optional step in addition to the step (A). For example, the method for producing the circuit board may include:
(B) a step of subjecting the magnetic layer to drilling processing;
(C) a step of subjecting the magnetic layer to a roughening treatment; and
(D) a step of forming a conductor layer on the magnetic layer.

This production method preferably includes the steps (A) to (D) in this order.

### <Step (A)>

The step (A) is a step of laminating the resin sheet on the inner layer substrate so that the resin composition layer is bonded to the inner layer substrate to form the magnetic layer. In an embodiment of the step (A), the resin sheet is laminated on the inner layer substrate so that the resin composition layer is bonded to the inner layer substrate, and the resin composition layer is heat-cured to form the magnetic layer.

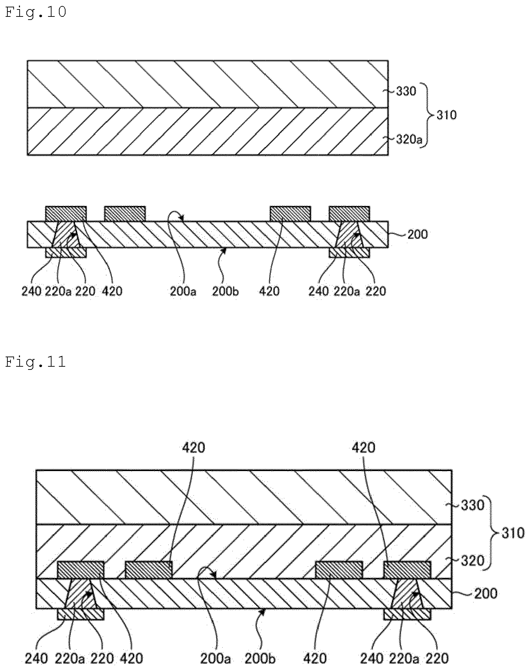

FIG. 10 is a schematic cross-sectional view for explaining the step (A) in the method for producing the circuit board according to the second embodiment of the present invention. In the step (A), a resin sheet 310 including a support 330 and a resin composition layer 320a provided on the support 330 is laminated on an inner layer substrate 200 so that the resin composition layer 320a is bonded to the inner layer substrate 200.

The inner layer substrate 200 is an insulating substrate. Examples of a material for the inner layer substrate 200 may include an insulating substrate such as a glass epoxy substrate, a metal substrate, a polyester substrate, a polyimide substrate, a BT resin substrate, and a thermosetting polyphenylene ether substrate. The inner layer substrate 200 may be an inner layer circuit board in which wiring or the like is built into its thickness.

As shown in an example in FIG. 10, the inner layer substrate 200 includes a first conductor layer 420 provided on a first main surface 200a and an external terminal 240 provided on a second main surface 200b. The first conductor layer 420 may include a plurality of wires. In the illustrated example, only wiring constituting a coiled conductive structure 400 of an inductor element is shown. The external terminal 240 is a terminal used for an electrical connection to an external device or the like not shown. The external terminal 240 can be configured as a part of a conductor layer provided on the second main surface 200b.

A conductor material that can constitute the first conductor layer 420 and the external terminal 240 is the same as that for the conductor layer described in the section of "<Step (5)>" in the first embodiment.

The first conductor layer 420 and the external terminal 240 may have a single-layer structure or a multilayer structure in which two or more single metal layers or alloy layers consisting of different types of metals or alloys are laminated. Furthermore, the thickness of the first conductor layer 420 and the external terminal 240 is the same as that of the second conductor layer 440 described below.

A line (L) / space (S) ratio of the first conductor layer 420 and the external terminal 240 is not particularly limited, and, from the viewpoint of obtaining the magnetic layer with reduced surface irregularities and excellent surface smoothness, the ratio is usually 900/900 µm or less, preferably 700/700 µm or less, more preferably 500/500 µm or less, further preferably 300/300 µm or less, and even further preferably 200/200 µm or less. The lower limit of the line / space ratio is not particularly limited, and, from the viewpoint of facilitating embedding of the resin composition layer into the space, the ratio is preferably 1/1 µm or more.

The inner layer substrate 200 may include a plurality of through holes 220 that penetrate the inner layer substrate 200 from the first main surface 200a to the second main surface 200b. The through hole 220 is provided with a through-hole wiring 220a. The through-hole wiring 220a electrically connects the first conductor layer 420 and the external terminal 240.

The bonding between the resin composition layer 320a and the inner layer substrate 200 is performed by the same method as that for laminating the core substrate and the resin sheet described in the section of "<Step (1)>" in the first embodiment.

After laminating the resin sheet on the inner layer substrate, the resin composition layer is heat-cured to form the magnetic layer. As shown in an example in FIG. 11, the resin composition layer 320a bonded to the inner layer substrate 200 is heat-cured to form a first magnetic layer 320.

The heat-curing conditions for the resin composition layer 320a are the same as those for the resin composition layer described in the section of "<Step (2)>" in the first embodiment.

The support 330 may be removed after the heat-curing in the step (A) but before the step (B), or after the step (B).

### <Step (B)>

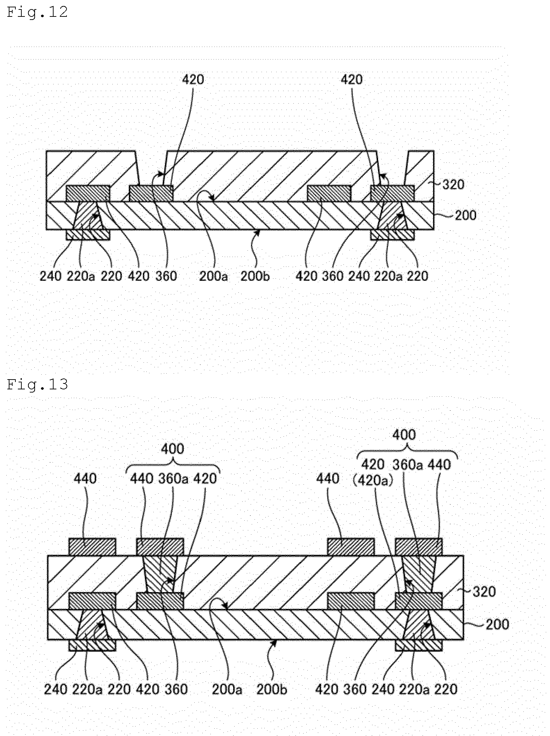

FIG. 12 is a schematic cross-sectional view for explaining the step (B) in the method for producing the circuit board according to the second embodiment of the present invention. In the step (B), the first magnetic layer 320 is subjected to drilling processing to form via holes 360.

The via holes 360 serve as a path for electrically connecting the first conductor layer 420 and the second conductor layer 440 described below. The via holes 360 may be formed using, for example, a drill, laser, plasma, or the like, depending on the chemical composition or the like of the resin composition used for forming the magnetic layer. The dimensions and shape of the via hole may be determined as appropriate depending on the design of the circuit board.

### <Step (C)>

The step (C) includes subjecting the magnetic layer, in which the via hole is formed, to a roughening treatment. The roughening treatment in the step (C) can be performed by the same method as that described in the section of "<Step (4)>" in the first embodiment.

The roughening treatment in the step (C) may be a treatment of polishing the surface of the insulating layer. As a polishing method, the same polishing as described in the section of "<Step (3)>" in the first embodiment can be performed.

From the viewpoint of improving plating adhesion, the arithmetic average roughness (Ra) of the surface of the magnetic layer to which the roughening treatment has been performed is preferably 300 nm or more, more preferably 350 nm or more, and further preferably 400 nm or more. The upper limit is preferably 1,000 nm or less, more preferably 900 nm or less, and further preferably 800 nm or less. The surface roughness (Ra) can be measured using, for example, a non-contact surface roughness meter.

### <Step (D)>

FIG. 13 is a schematic cross-sectional view for explaining the step (D) in the method for producing the circuit board according to the second embodiment of the present invention. The step (D) includes forming the second conductor layer 440 on the first magnetic layer 320, as shown in an example in FIG. 13.

A conductor material that can constitute the second conductor layer 440 is the same as that for the conductor layer described in the section of "<Step (5)>" in the first embodiment.

The thickness of the second conductor layer 440 is, from the viewpoint of thinning, preferably 70 µm or less, more preferably 60 µm or less, further preferably 50 µm or less, even further preferably 40 µm or less, particularly preferably 30 µm or less, 20 µm or less, 15 µm or less, or 10 µm or less. The lower limit is preferably 1 µm or more, more preferably 3 µm or more, and further preferably 5 µm or more.

The second conductor layer 440 can be formed by plating. The second conductor layer 440 is preferably formed, for example, by a wet plating method such as a semi-additive method or a fully-additive method, including an electroless plating step, a mask pattern forming step, an electrolytic plating step, and a flash etching step. Forming the second conductor layer 440 using the wet plating method makes it possible to form the second conductor layer 440 with a desired wiring pattern. Note that, through this step, via-hole wirings 360a are also formed inside the via holes 360.

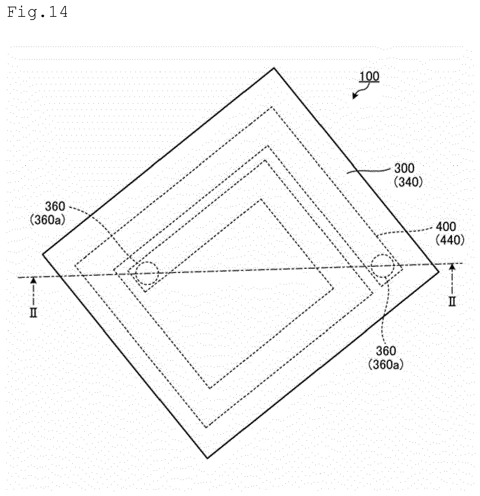

The first conductor layer 420 and the second conductor layer 440 may be provided in a spiral shape, for example, as shown in an example in FIGS. 14 to 16 described below. In one example, one end of a spiral wiring portion of the second conductor layer 440 on the center side is electrically connected to one end of a spiral wiring portion of the first conductor layer 420 on the center side by the via-hole wiring 360a. The other end of the spiral wiring portion of the second conductor layer 440 on the outer peripheral side is electrically connected to a land 420a of the first conductor layer 42 by the via-hole wiring 360a. Thus, the other end of the spiral wiring portion of the second conductor layer 440 on the outer peripheral side is electrically connected to the external terminal 240 via the via-hole wiring 360a, the land 420a, and the through-hole wiring 220a.

The coiled conductive structure 400 is constituted by the spiral wiring portion that is a part of the first conductor layer 420, the spiral wiring portion that is a part of the second conductor layer 440, and the via-hole wiring 360a that electrically connects the spiral wiring portion of the first conductor layer 420 and the spiral wiring portion of the second conductor layer 440.

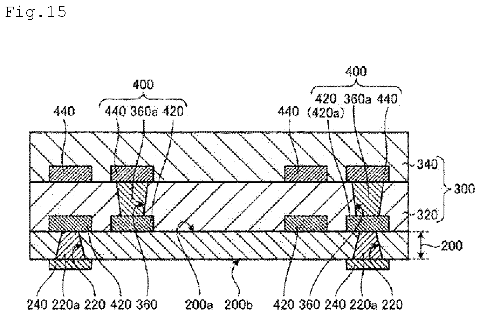

After the step (D), a step of forming the magnetic layer on the conductor layer may be further performed. In detail, as shown in an example in FIG. 15, a second magnetic layer 340 is formed on the first magnetic layer 320 in which the second conductor layer 440 and the via-hole wiring 360a are formed. The second magnetic layer may be formed by the same steps as those already described.

### [Inductor component]

An inductor component includes the circuit board of the present invention. When the inductor component includes the circuit board obtained by the method for producing the circuit board of the first embodiment, the inductor component has an inductor pattern formed by a conductor at least at a part of the periphery of the cured product of the resin composition layer described above. As such an inductor component, for example, the one described in Japanese Patent Application Laid-Open No. 2016-197624 A can be adopted.

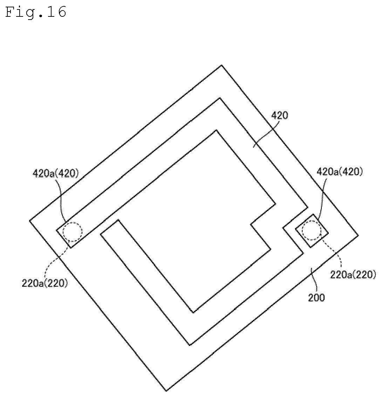

Furthermore, when the inductor component includes the circuit board obtained by the method for producing the circuit board of the second embodiment, the inductor substrate includes the magnetic layer and the conductive structure at least partially embedded in this magnetic layer. Thus, the inductor substrate includes an inductor element constituted by this conductive structure and a part of the magnetic layer that extends in the thickness direction of the magnetic layer and that is surrounded by the conductive structure. FIG. 14 is a schematic plan view of the inductor substrate including the built-in inductor element, viewed from one side in the thickness direction of the inductor substrate. FIG. 15 is a schematic view showing a cut end surface of the inductor substrate cut at the position indicated by a dashed line II-II shown in FIG. 14. FIG. 16 is a schematic plan view for explaining a configuration of the first conductor layer of the inductor substrate.

As shown in an example in FIGS. 14 and 15, the circuit board 100 includes a plurality of the magnetic layers (the first magnetic layer 320 and the second magnetic layer 340) and a plurality of the conductor layers (the first conductor layer 420 and the second conductor layer 440). That is, the circuit board 100 is a build-up wiring board including a build-up magnetic layer and a build-up conductor layer. Furthermore, the circuit board 100 includes the inner layer substrate 200.

In FIG. 15, the first magnetic layer 320 and the second magnetic layer 340 constitute a magnetic portion 300 that can be considered as an integrated magnetic layer. Accordingly, the coiled conductive structure 400 is provided so that at least a part of the coiled conductive structure 400 is embedded in the magnetic part 300. That is, in the circuit board 100 of the present embodiment, the inductor element is constituted by the coiled conductive structure 400 and a core portion, which is a part of the magnetic portion 300, extending in the thickness direction of the magnetic portion 300 and surrounded by the coiled conductive structure 400.

As shown in an example in FIG. 16, the first conductor layer 420 includes a spiral wiring portion for constituting the coiled conductive structure 400 and the rectangular land 420a electrically connected to the through-hole wiring 220a. In the illustrated example, the spiral wiring portion includes a straight portion, a bent portion that is bent at a right angle, and a detour portion that detours around the land 420a. In the illustrated example, the spiral wiring portion of the first conductor layer 420 has a substantially rectangular shape as an overall outline and has a shape of winding counterclockwise from the center toward the outside.

Similarly, the second conductor layer 440 is provided on the first magnetic layer 320. The second conductor layer 440 includes a spiral wiring portion for constituting the coiled conductive structure 400. In FIG. 14 or FIG. 15, the spiral wiring portion includes a straight portion and a bent portion that is bent at a right angle. In FIG. 14 or FIG. 15, the spiral wiring portion of the second conductor layer 440 has a substantially rectangular shape as an overall outline and has a shape of winding clockwise from the center toward the outside.

Such an inductor component can be used as a wiring board for mounting an electronic component such as a semiconductor chip or as a (multilayer) printed wiring board using such a wiring board as an inner layer substrate. Furthermore, the inductor component can also be used as a chip inductor component obtained by making such a wiring board into individual pieces or as a printed wiring board onto which the chip inductor component is surface-mounted.

Furthermore, various types of semiconductor devices can be produced using such a wiring board. A semiconductor device including such a wiring board can be suitably used in an electrical product (e.g., a computer, a mobile phone, a digital camera, a television, etc.), a vehicle (e.g., a motorcycle, an automobile, a train, a ship, an aircraft, etc.), and the like.

### [Examples]

The present invention is specifically described below with reference to Examples. However, the present invention is not limited to these Examples. Note that, in the following description, "part(s)" and "%" representing the amount(s) mean "part(s) by mass" and "% by mass", respectively, unless otherwise specified.

### <Measurement of pH of dispersant (indicator method)>

A dispersant was dissolved in acetone to produce a measurement sample (22°C) with a dispersant concentration of 0.1 g/mL. A pH test paper was gently dipped in the measurement sample and then pulled out to dry excess water content. The color of the wet part of the test paper was compared with the color sample, and pH of the closest color was defined as the pH of each sample.

### <Synthesis example 1: Synthesis of dispersant 1>

Into a reaction flask equipped with a thermometer, a stirrer, a nitrogen inlet, and a reflux tube, 10.0 parts of 12-hydroxystearic acid (manufactured by Junsei Chemical Co., Ltd.) and 190 parts of ε-caprolactone (manufactured by Junsei Chemical Co., Ltd.) were charged. The mixture was heated to 160°C over 4 hours under nitrogen flow, and then heated at 160°C for 2 hours. Heating was continued until the remaining amount of ε-caprolactone became 1% or less. Then, the mixture was cooled to room temperature. Hereinbelow, this reaction liquid is referred to as a dispersant 1. The dispersant 1 had a weight-average molecular weight of 23,000 and an acid value of 9.0 mgKOH/g. The pH was 5 according to the indicator method.

### <Synthesis example 2: Synthesis of dispersant 2>

Into a reaction flask equipped with a thermometer, a stirrer, a nitrogen inlet, and a reflux tube, 10.0 parts of 12-hydroxystearic acid (manufactured by Junsei Chemical Co., Ltd.) and 180 parts of δ-valerolactone (manufactured by Tokyo Chemical Industry Co., Ltd.) were charged. The mixture was heated to 160°C over 4 hours under nitrogen flow, and then heated at 160°C for 2 hours. Heating was continued until the remaining amount of δ-valerolactone became 1% or less. Then, the mixture was cooled to room temperature. Hereinbelow, this reaction liquid is referred to as a dispersant 2. The dispersant 2 had a weight-average molecular weight of 22,000 and an acid value of 8.9 mgKOH/g. The pH was 5 according to the indicator method.

### <Synthesis example 3: Synthesis of dispersant 3>

In a reaction flask equipped with a thermometer, a stirrer, a nitrogen inlet, and a reflux tube, a mixture including 25.0 parts of xylene and 70 parts of a 10% polyallyamine aqueous solution ("PAA-1LV" manufactured by Nitto Boseki Co., Ltd., number-average molecular weight: about 3,000) was stirred at 160°C. Water wad distilled off using a separation device while xylene was returned to the reaction solution. To this mixture, 14.21 parts of the dispersant 1 that was obtained in the synthesis example 1 and heated to 160°C was added to perform a reaction at 160°C over 2 hours.

Additional heating was performed at 160°C for 4 hours, and xylene was distilled off at 160°C to obtain a dispersant 3. The dispersant 3 had a characteristic in which an amine value was 31.0 mgKOH/g. The dispersant 3 had a characteristic in which the amine value immediately after mixing was 312.6 mgKOH/g. The pH was 6 according to the indicator method.

### <Synthesis example 4: Synthesis of dispersant 4>

Into a reaction flask equipped with a thermometer, a stirrer, a nitrogen inlet, a reflux tube, and a water separator, 30.0 parts of xylene (manufactured by Junsei Chemical Co., Ltd.), 300.0 parts of 12-hydroxystearic acid (manufactured by Junsei Chemical Co., Ltd.), and 0.1 part of tetrabutyltitanate (manufactured by Tokyo Chemical Industry Co., Ltd.) were charged. The mixture was heated to 160°C over 4 hours under nitrogen flow, and then further heated at 160°C for 4 hours. Xylene was distilled off at 160°C to obtain a dispersant 4. The dispersant 4 had a weight-average molecular weight of 6,000 and an acid value of 23.0 mgKOH/g. The pH was 5 according to the indicator method.

### <Synthesis example 5: Synthesis of dispersant 5>

Into a reaction flask equipped with a thermometer, a stirrer, a nitrogen inlet, a reflux tube, and a water separator, 30.0 parts of xylene (manufactured by Junsei Chemical Co., Ltd.), 300.0 parts of 12-hydroxystearic acid (manufactured by Junsei Chemical Co., Ltd.), and 0.1 part of tetrabutyltitanate (manufactured by Tokyo Chemical Industry Co., Ltd.) were charged. The mixture was heated to 160°C over 4 hours under nitrogen flow, and then further heated at 160°C for 4 hours (at this time the acid value was about 20 mgKOH/g). Xylene was distilled off at 160°C. Then, the mixture was cooled to room temperature, and water generated during heating reaction was separated from xylene in the distilled-off product. The separated xylene was returned to the reaction solution. This reaction liquid is referred to as a polyester PE-1.

In a reaction flask equipped with a thermometer, a stirrer, a nitrogen inlet, a reflux tube, and a water separator, a mixture including 25.0 parts of xylene and 70 parts of a 10% polyallyamine aqueous solution ("PAA-1LV" manufactured by Nitto Boseki Co., Ltd., number-average molecular weight: about 3,000) was stirred at 160°C. Water wad distilled off using a separation device while xylene was returned to the reaction solution. To this mixture, 2.5 parts of the polyester PE-1 was added and a reaction was performed at 160°C over 2 hours.
Additional heating was performed at 160°C for 4 hours, and xylene was distilled off at 160°C. A dispersant 5 had a polyester skeleton in which R in the general formula (1) is an alkylene group of 11 carbon atoms, and had a characteristic in which an amine value was 38.5 mgKOH/g and an acid value of 23.5 mgKOH/g. The dispersant 5 immediately after mixing had an amine value of 317 mgKOH/g. The pH of the dispersant 5 was 6 according to the indicator method.

### <Example 1: Production of magnetic varnish 1>

A magnetic varnish 1 was prepared by mixing 2.41 parts by mass of an epoxy resin ("ZX-1059", a mixture of a bisphenol A type epoxy resin and a bisphenol F type epoxy resin, manufactured by Nippon Steel Chemical & Material Co., Ltd.), 2.74 parts by mass of a triazine skeleton-containing phenol resin ("LA-7054" manufactured by DIC Corp., a MEK solution with hydroxyl equivalent of about 125 and a solid content of 60%), 2.39 parts by mass of a phenoxy resin ("YL7553BH30" manufactured by Mitsubishi Chemical Corporation, 1:1 solution of MEK and cyclohexanone with solid content of 30%), 0.5 part by mass of the dispersant 1 (dispersant synthesized in Synthesis example 1, polyester dispersant of 5 carbon atoms), 3.0 parts by mass of a solvent (cyclohexanone), 0.02 part by mass of an imidazole-based curing accelerator ("2E4MZ", 2-ethyl-4-methyl imidazole, manufactured by Shikoku Chemicals Corp.), 27.91 parts by mass of a magnetic powder ("M03S", Fe-Mn ferrite, average particle diameter of 0.4 µm, specific gravity of 5.1 m²/g, manufactured by Powdertech), and 93.19 parts by mass of a magnetic powder ("MA-RCO-24" manufactured by Dowa Electronics Materials Co., Ltd., Fe-Ni alloy, average particle diameter of 3.0 µm).

### <Example 2: Preparation of magnetic varnish 2>

A magnetic varnish 2 was prepared by the same manner as that in Example 1, except that the content of the dispersant 1 (dispersant synthesized in Synthesis example 1, which is a polyester dispersant of 5 carbon atoms) was changed from 0.5 part by mass to 1 part by mass in Example 1.

### <Example 3: Preparation of magnetic varnish 3>

A magnetic varnish 3 was prepared by the same manner as that in Example 1, except that the content of the dispersant 1 (dispersant synthesized in Synthesis example 1, which is a polyester dispersant of 5 carbon atoms) was changed from 0.5 part by mass to 0.1 part by mass in Example 1.

### <Example 4: Preparation of magnetic varnish 4>

A magnetic varnish 4 was prepared by the same manner as that in Example 1, except that 0.5 part by mass of the dispersant 1 (dispersant synthesized in Synthesis example 1, which is a polyester dispersant of 5 carbon atoms) was changed to 0.5 part by mass of the dispersant 2 (dispersant synthesized in Synthesis example 2, which is a polyester dispersant of 4 carbon atoms) in Example 1.

### <Example 5: Preparation of magnetic varnish 5>

A magnetic varnish 5 was prepared by the same manner as that in Example 1, except that 0.5 part by mass of the dispersant 1 (dispersant synthesized in Synthesis example 1, which is a polyester dispersant of 5 carbon atoms) was changed to 0.5 part by mass of the dispersant 3 (dispersant synthesized in Synthesis example 3, which is a dispersant containing a polyester of 5 carbon atoms) in Example 1.

### <Example 6: Preparation of magnetic varnish 6>

A magnetic varnish 6 was prepared by the same manner as that in Example 1, except that 27.91 parts by mass of the magnetic powder ("M03S", Fe-Mn ferrite, average particle diameter of 0.4 µm, specific gravity of 5.1 m²/g, manufactured by Powdertech) was changed to 27.91 parts by mass of a magnetic powder ("MZ03S", Fe-Mn-Zn ferrite, average particle diameter of 0.4 µm, specific gravity of 5.1 m²/g, manufactured by Powdertech), in Example 1.

### <Comparative Example 1: Preparation of magnetic varnish 7>

A magnetic varnish 7 was prepared by the same manner as that in Example 1, except that 0.5 part by mass of the dispersant 1 (dispersant synthesized in Synthesis example 1, which is a polyester dispersant of 5 carbon atoms) was changed to 0.5 part by mass of the dispersant 4 (dispersant synthesized in Synthesis example 4, which is a polyester dispersant of 11 carbon atoms, Synthesis example 4) in Example 1.

### <Comparative Example 2: Preparation of magnetic varnish 8>

A magnetic varnish 8 was prepared by the same manner as that in Example 1, except that 0.5 part by mass of the dispersant 1 (dispersant synthesized in Synthesis example 1, which is a polyester dispersant of 5 carbon atoms) was changed to 0.5 part by mass of the dispersant 5 (dispersant synthesized in Synthesis example 5, which is a dispersant containing a polyester of 11 carbon atoms) in Example 1.

### <Comparative Example 3: Preparation of magnetic varnish 9>

A magnetic varnish 9 was prepared by the same manner as that in Example 1, except that 0.5 part by mass of the dispersant 1 (dispersant synthesized in Synthesis example 1, which is a polyester dispersant of 5 carbon atoms) was changed to 0.5 part by mass of a dispersant (ED-152, which is a dispersant with no polyester skeleton, manufactured by Kusuimoto Chemicals, Ltd.) in Example 1.

### <Comparative Example 4: Preparation of magnetic varnish 10>

A magnetic varnish 10 was prepared by the same manner as that in Example 1, except that 0.5 part by mass of the dispersant 1 (dispersant synthesized in Synthesis example 1, which is a polyester dispersant of 5 carbon atoms) was changed to 0.5 part by mass of a dispersant (SC-1015F, which is a dispersant with no polyester skeleton, manufactured by NOF Corp.) in Example 1.

### <Preparation of resin sheet>

The magnetic varnish produced in Examples and Comparative Examples was applied onto a PET film ("LUMIRROR R80" manufactured by Toray Industries, Inc., thickness of 38 µm, softening point of 130°C, hereinafter also referred to as "release PET") that had been subjected to a release treatment using an alkyd resin-based release agent ("AL-5" manufactured by Lintec Corp.) using a die coater so that the thickness of the resin composition layer after drying became 100 µm, followed by drying for 7 minutes at 65°C to 115°C (100°C on average) to obtain a resin sheet.

### <Production of sheet-shaped cured product>

The resin sheet was cut into a 200-mm square piece. The cut resin sheet (200-mm square) was laminated on one side of a polyimide film ("UPILEX 25S" manufactured by UBE Corp., 25-µm thick, 240-mm square) so that the resin composition layer was brought into contact with the center of the smooth surface of the polyimide film using a batch type vacuum-pressurization laminator (2-stage build-up laminator "CVP700" manufactured by Nikko-Materials Co., Ltd.). Lamination was performed by reducing the pressure for 30 seconds to 13 hPa or lower and then press-bonding the resin sheet at 100°C under a pressure of 0.74 MPa for 30 seconds. In this manner, a multilayer film having a layer configuration of support / resin composition layer / polyimide film was obtained. After peeling off the support, the resin composition layer was heat-cured by heating it at 190°C for 90 minutes. After that, the polyimide film was peeled off to obtain a sheet-shaped cured product of the resin composition.

### <Measurement of relative permeability and magnetic loss>

The obtained sheet-shaped cured product was cut to obtain an evaluation sample with a width of 5 mm and a length of 18 mm. The relative permeability (µ') and magnetic loss (µ") of this evaluation sample were measured using the three-turn coil method at a measurement frequency of 50 MHz and at a room temperature of 23°C using a device from Agilent Technologies, Inc. ("HP8362B" manufactured by Agilent Technologies, Inc.). The magnetic loss was calculated using the following formula "tanδ = µ'/µ"". Furthermore, the relative permeability was evaluated according to the following criteria.
O: relative permeability of 20 or more
X: relative permeability of less than 20

### <Measurement of mechanical strength (tensile strength at break)>

The tensile strength at break of the obtained sheet-shaped cured product was measured according to JIS K7127. The measurement results were evaluated according to the following criteria.
O: 60 MPa or more
X: less than 60 MPa

**[Table 1]**

| (Table 1) | | | | | | | | | | | |
|---|---|---|---|---|---|---|---|---|---|---|---|
| | | Example | | | | | | Comparative Example | | | |
| | | 1 | 2 | 3 | 4 | 5 | 6 | 1 | 2 | 3 | 4 |
| Component (A) | M03S | 27.91 | 27.91 | 27.91 | 27.91 | 27.91 | | 27.91 | 27.91 | 27.91 | 27.91 |
| | MZ03S | | | | | | 27.91 | | | | |
| | MA-RCO-24 | 93.19 | 93.19 | 93.19 | 93.19 | 93.19 | 93.19 | 93.19 | 93.19 | 93.19 | 93.19 |
| Component (B) | ZX-1059 | 2.41 | 2.41 | 2.41 | 2.41 | 2.41 | 2.41 | 2.41 | 2.41 | 2.41 | 2.41 |
| Component (C) | Dispersant 1 | 0.5 | 1 | 0.1 | | | 0.5 | | | | |
| | Dispersant 2 | | | | 0.5 | | | | | | |
| | Dispersant 3 | | | | | 0.5 | | | | | |
| Other Dispersants | Dispersant 4 | | | | | | | 0.5 | | | |
| | Dispersant 5 | | | | | | | | 0.5 | | |
| | ED-152 | | | | | | | | | 0.5 | |
| | SC-1015F | | | | | | | | | | 0.5 |
| Component (D) | LA-7054 | 2.74 | 2.74 | 2.74 | 2.74 | 2.74 | 2.74 | 2.74 | 2.74 | 2.74 | 2.74 |
| | 2E4MZ | 0.02 | 0.02 | 0.02 | 0.02 | 0.02 | 0.02 | 0.02 | 0.02 | 0.02 | 0.02 |
| Component (E) | YX7553BH30 | 2.39 | 2.39 | 2.39 | 2.39 | 2.39 | 2.39 | 2.39 | 2.39 | 2.39 | 2.39 |
| Component (F) | Solvent | 3 | 3 | 3 | 3 | 3 | 3 | 3 | 3 | 3 | 3 |
| Relative Permeability (50MHz) | | 21 | 21.3 | 20.7 | 21.1 | 21 | 22.5 | 17.7 | 17.2 | 18.5 | 19 |
| Magnetic Loss (50MHz) | | 0.06 | 0.05 | 0.07 | 0.04 | 0.06 | 0.05 | 0.04 | 0.04 | 0.05 | 0.04 |
| Evaluation Of Relative Permeability | | ○ | ○ | ○ | ○ | ○ | ○ | × | × | × | × |
| Mechanical Strength (MPa) | | 83 | 79 | 84 | 70 | 77 | 77 | 32 | 39 | 44 | 58 |
| Evaluation Of Mechanical Strength | | ○ | ○ | ○ | ○ | ○ | ○ | × | × | × | × |

### Reference Signs List

- 10: core substrate
- 10U: first surface
- 10D: second surface
- 11: supporting substrate
- 12: metal layer
- 13: metal layer
- 14: through hole
- 20: plating layer
- 30: resin sheet
- 31: resin composition layer
- 32: support
- 40: magnetic layer
- 40U: polished surface
- 40D: polished surface
- 50: conductor layer
- 51: patterned conductor layer
- 100: circuit board
- 200: inner layer substrate
- 200a: first main surface
- 200b: second main surface
- 220: through hole
- 220a: through-hole wiring
- 240: external terminal
- 300: magnetic portion
- 310: resin sheet
- 320a: resin composition layer
- 320: first magnetic layer
- 330: support
- 340: second magnetic layer
- 360: via hole
- 360a: via-hole wiring
- 400: coiled conductive structure
- 420: first conductor layer
- 420a: land
- 440: second conductor layer

## Claims

1. A resin sheet comprising: a support; and a resin composition layer formed of a resin composition provided on the support, wherein
the resin composition includes
a magnetic powder (A),
an epoxy resin (B),
a dispersant (C),
a curing agent (D), and
a thermoplastic resin (E), and
the component (C) has a polyester skeleton represented by the following general formula (1): 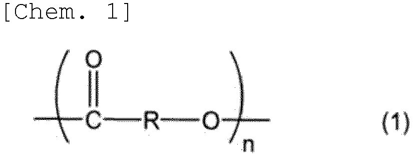 (in the general formula (1), Rs each independently represent a hydrocarbon group of 2 to 10 carbon atoms, and n represents an integer of 2 to 1,000).

2. The resin sheet according to claim 1, wherein a content of the component (C) is 0.1% by mass or more, and 5% by mass or less, when a nonvolatile component in the resin composition is defined as 100% by mass.

3. The resin sheet according to claim 1 or 2, wherein the component (A) includes a magnetic powder (A-1) with an average particle diameter of 1 µm or more and a magnetic powder (A-2) with an average particle diameter of less than 1 µm.

4. The resin sheet according to any one of claims 1 to 3, wherein the component (A) includes a magnetic powder (A-1) with an average particle diameter of 1 µm or more and 10 µm or less and a magnetic powder (A-2) with an average particle diameter of 0.005 µm or more and less than 1 µm.

5. The resin sheet according to any one of claims 1 to 4, wherein the component (A) is at least one type selected from an iron oxide powder and an iron alloy metal powder.

6. The resin sheet according to any one of claims 1 to 5, wherein the component (A) includes an iron oxide powder, and the iron oxide powder includes a ferrite including at least one type selected from Ni, Cu, Mn, and Zn.

7. The resin sheet according to any one of claims 1 to 6, wherein a content of the component (A) is 70% by mass or more and 98% by mass or less, when a nonvolatile component in the resin composition is defined as 100% by mass.

8. The resin sheet according to any one of claims 1 to 7, wherein, when a mass (% by mass) of the thermoplastic resin (E) is defined as E1 when a nonvolatile component in the resin composition is defined as 100% by mass, and a mass (% by mass) of the epoxy resin (B) is defined as B1 when the nonvolatile component in the resin composition is defined as 100% by mass, B1/E1 is 0.1 or more and 5 or less.

9. The resin sheet according to any one of claims 1 to 8, used for forming a magnetic layer of a circuit board.

10. The resin sheet according to any one of claims 1 to 9, used for filling a through hole.

11. A circuit board comprising a magnetic layer that is a cured product of the resin composition layer of the resin sheet according to any one of claims 1 to 10.

12. A circuit board comprising a substrate in which a through hole has been formed, and a magnetic layer filled in the through hole, wherein
the magnetic layer includes a cured product of the resin composition layer of the resin sheet according to any one of claims 1 to 10.

13. An inductor component comprising the circuit board according to claim 11 or 12.

14. A resin composition comprising:
a magnetic powder (A);
an epoxy resin (B);
a dispersant (C);
a curing agent (D); and
a thermoplastic resin (E), wherein:
when a mass (% by mass) of the thermoplastic resin (E) is defined as E1 when a nonvolatile component in the resin composition is defined as 100% by mass, and a mass (% by mass) of the epoxy resin (B) is defined as B1 when the nonvolatile component in the resin composition is defined as 100% by mass, B1/E1 is 0.1 or more and 5 or less, and
the component (C) has a polyester skeleton represented by the following general formula (1). 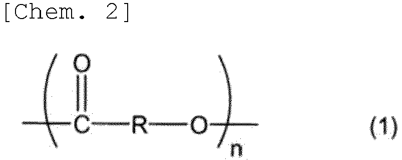 (in the general formula (1), Rs each independently represent a hydrocarbon group of 2 to 10 carbon atoms, and n represents an integer of 2 to 1,000).

15. A circuit board comprising a magnetic layer that is a cured product of the resin composition according to claim 14.

16. A circuit board comprising a substrate having a through hole, and a cured product of the resin composition according to claim 14, the cured product being filled in the through hole.

17. An inductor component comprising the circuit board according to claim 15 or 16.
